(19) **Europäisches Patentamt / European Patent Office / Office européen des brevets**

(11) **EP 3 230 666 B1**

(12) ## EUROPÄISCHE PATENTSCHRIFT

(45) Veröffentlichungstag und Bekanntmachung des Hinweises auf die Patenterteilung:
**27.01.2021   Patentblatt 2021/04**

(21) Anmeldenummer: **15805142.5**

(22) Anmeldetag: **02.12.2015**

(51) Int Cl.:
*F25D 19/00* (2006.01)          *H01F 6/04* (2006.01)

(86) Internationale Anmeldenummer:
**PCT/EP2015/078280**

(87) Internationale Veröffentlichungsnummer:
**WO 2016/091667 (16.06.2016 Gazette 2016/24)**

(54) **KRYOSTAT MIT EINEM ERSTEN UND EINEM ZWEITEN HELIUMTANK, DIE ZUMINDEST IN EINEM UNTEREN BEREICH FLÜSSIGKEITSDICHT VONEINANDER ABGETRENNT SIND**

CRYOSTAT HAVING A FIRST AND A SECOND HELIUM TANK, WHICH ARE SEPARATED FROM ONE ANOTHER IN A LIQUID-TIGHT MANNER AT LEAST IN A LOWER PART

CRYOSTAT COMPRENANT UN PREMIER ET UN DEUXIÈME RÉSERVOIR D'HÉLIUM, QUI SONT SÉPARÉS L'UN DE L'AUTRE DE MANIÈRE ÉTANCHE AU LIQUIDE AU MOINS DANS UNE ZONE INFÉRIEURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2014   DE 102014225481**

(43) Veröffentlichungstag der Anmeldung:
**18.10.2017   Patentblatt 2017/42**

(73) Patentinhaber: **Bruker BioSpin GmbH**
**76287 Rheinstetten (DE)**

(72) Erfinder:
• **STROBEL, Marco**
**76137 Karlsruhe (DE)**
• **WIKUS, Patrick**
**76351 Linkenheim (DE)**

• **ROTH, Gerhard**
**76287 Rheinstetten (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
EP-A2- 0 212 093          JP-A- S 611 962
JP-A- H0 979 677          JP-A- H08 240 353
JP-A- 2001 330 328

• YANG L C ET AL: "Characterization of superfluid helium transfer", CRYOGENICS, ELSEVIER, KIDLINGTON, GB, Bd. 21, Nr. 4, 1. April 1981 (1981-04-01), Seiten 207-212, XP024048290, ISSN: 0011-2275, DOI: 10.1016/0011-2275(81)90196-X [gefunden am 1981-04-01]

EP 3 230 666 B1

**Beschreibung**

Die Erfindung betrifft einen Kryostat, mit

- einem ersten Heliumtank, der in einem unteren Teil mit flüssigem Helium, insbesondere superflüssigem Helium, mit einer Temperatur < 2,5 K und in einem oberen Teil zumindest teilweise mit flüssigem Helium, insbesondere normalflüssigem Helium, mit einer Temperatur > 4 K befüllt ist, derart, dass der erste Heliumtank einen ersten Bereich aufweist, der vom unteren Ende des unteren Teils bis zu einer ersten Flüssigkeitsoberfläche im oberen Teil durchgehend mit flüssigem Helium gefüllt ist,
- und mit einer Joule-Thomson-Kühleinheit, mit der das flüssige Helium im unteren Teil des ersten Heliumtanks durch expandierendes Helium über einen Wärmetauscher gekühlt werden kann.

Ein solcher Kryostat ist aus der DE 10 2010 028 750 B4 bekannt geworden.

Kernspinresonanz(=NMR)-Apparaturen, insbesondere NMR-Spektrometer und NMR-Tomographen, benötigen starke Magnetfelder, die oftmals mittels supraleitender Magnetspulen erzeugt werden. Die supraleitenden Magnetspulen müssen auf einer kryogenen Temperatur betrieben werden. Die Magnetspulen sind dafür typischerweise im Kryotank eines Kryostaten angeordnet, welcher mit einer kryogenen Flüssigkeit befüllt ist.

Besonders tiefe Temperaturen im Kryostaten können mit flüssigem Helium erreicht werden. Helium siedet bei Normaldruck bei einer Temperatur von ca. 4,2 K.

Um Temperaturen von weniger als 4,2 K zu erreichen, kann an einem Bad von flüssigem Helium gepumpt werden. Die Reduktion des Dampfdrucks führt zu einer Abkühlung des Bads. Dieses Vorgehen hat den Nachteil, dass im Heliumtank Unterdruck herrscht. Bei Fehlbedienung oder einem kleinen Leck im System kann das schwerwiegende Folgen haben (Ansaugen von Luft, Ausfrieren der Luft im Inneren des Systems, Blockade von Abströmleitungen).

Ebenso kann mit Hilfe einer Joule-Thomson-Kühleinheit flüssiges Helium mit einer Temperatur von weniger als 2,5 K, insbesondere im superflüssigen Zustand, erzeugt werden. In der Praxis, beispielsweise beschrieben in der DE 10 2010 028 750 B4, ist dafür typischerweise ein Heliumtank vorgesehen, der in einer unteren, ersten Kammer (unterer Teil) mit flüssigem Helium bei ca. 2 K befüllt ist, und der in einer oberen, zweiten Kammer (oberer Teil) mit flüssigem Helium bei ca. 4,2 K befüllt. Dazwischen ist eine wärmeisolierende Barriere angeordnet. Eine Joule-Thomson-Kühleinheit saugt flüssiges Helium aus der oberen oder unteren Kammer an, expandiert dieses und kühlt dadurch die untere Kammer des Heliumtanks ab. Das expandierte Helium wird abgepumpt.

Dieses System vermeidet es, im ganzen Heliumtank Unterdruck zu erzeugen; Unterdruck herrscht nur in der verhältnismäßig kleinen Joule-Thomson-Kühleinheit. Dafür ist eine Thermalbarriere nötig, die zwar thermisch isoliert, den Druck des oberen Tanks aber auf den unteren Tank überträgt (das ist z.B. gegeben, wenn die Barriere für flüssiges Helium durchlässig ist, oder als thermisch isolierende Membran ausgeführt wird). Thermodynamisch gesehen ist das Helium im unteren Tank "unterkühlt", d.h. der tatsächlich herrschende Druck ist größer als der der Temperatur entsprechende Dampfdruck.

Die Joule-Thomson Kühleinheit verbraucht zur Kühlung des unteren Teils des Heliumtanks flüssiges Helium, wodurch der Füllstand im oberen Teil des Heliumtanks sinkt. Durch die Rückführung eines Teils des abgepumpten Heliums in den oberen Teil, vorgeschlagen in der DE 10 2010 028 750 B4, kann der Heliumverbrauch des Kryostaten gesenkt werden. Auch dann muss jedoch noch in regelmäßigen Abständen flüssiges Helium in den Heliumtank nachgefüllt werden. Das Nachfüllen des flüssigen Heliums ist für den Anwender mühsam; zudem ist ein hochauflösendes NMR-System nach dem Nachfüllen für einige Tage nur beschränkt einsetzbar. Daher sollte ein Nachfüllen möglichst selten stattfinden müssen.

Grundsätzlich können die Intervalle, in denen flüssiges Helium nachgefüllt werden muss, dadurch verlängert werden, dass der obere Teil des Heliumtanks vergrößert wird, um eine größere Menge an flüssigem Helium bei 4,2 K vorzuhalten, und so den unteren Teil des Heliumtanks länger kühlen zu können. Dadurch vergrößert sich jedoch die Bauhöhe des Kryostaten. In typischen Laboratorien ist die maximale Bauhöhe des Kryostaten jedoch durch die Deckenhöhe begrenzt, bzw. höhere Deckenhöhen würden hohe Umbaukosten im Laborgebäude verursachen, sofern ein Umbau überhaupt möglich ist.

Um den Heliumverbrauch weiter zu begrenzen ist es möglich, das abgepumpte Helium über eine zusätzliche aktive Kühleinrichtung, etwa einen Pulsrohrkühler, zurückzuführen, wodurch das verbrauchte flüssige Helium im oberen Teil wieder aufgefüllt werden kann. Bei Ausfall oder Reparatur der aktiven Kühleinrichtung verbraucht aber auch hier die Joule-Thomson-Kühleinheit das flüssige Helium des oberen Teils, und das Volumen des oberen Teils des Heliumtanks begrenzt die Zeitspanne, während der ein Ausfall der aktiven Kühleinrichtung bei Aufrechterhaltung der Kühlung durch die Joule-Thomson-Kühleinheit überbrückt werden kann. Um die überbrückbare Zeitspanne zu vergrößern, müsste wiederum die Bauhöhe des Kryostaten vergrößert werden.

Falls vorgesehen ist, eine Shimeinrichtung von oben in eine Raumtemperaturbohrung des Kryostaten einzuführen, wird oberhalb des Kryostaten nochmals ein freier Raum von etwa der Höhe des oberen Teils des Heliumtanks benötigt, was die maximale Bauhöhe des Kryostaten in Hinblick auf die verfügbare Deckenhöhe in einem Laborraum zusätzlich reduziert.

Aus der JP 2001 330 328 A ist ein Kryostat bekannt geworden, bei dem ein Tank für superflüssiges Helium unter einen Tank für normalflüssiges Helium angeordnet und über einen Separator getrennt ist. Der Tank für normalflüssiges Helium ist aufgeteilt auf einen ersten Heliumtank, an dessen Unterseite der Separator angeordnet ist, und einen zweiten Heliumtank. An der Unterseite des zweiten Heliumtanks ist eine Rohrverbindung in den ersten Heliumtank vorgesehen. Mit diesem Kryostaten soll der Wärmeeintrag in den Tank für superflüssiges Helium vermindert werden, und gleichzeitig ein gutes Fassungsvermögen des Tanks für normalflüssiges Helium sichergestellt werden.

Die JP S61 1962 A beschreibt eine Vorrichtung zum Erzeugen von flüssigem Helium. In einem oberen Tank ist normalfluides Helium angeordnet, und in einem unteren Tank ist ungesättigtes superfluides Helium angeordnet. Vom oberen Tank führt eine Heliumleitung über ein Joule-Thompson-Ventil zu einem Leitungsabschnitt, der im unteren Heliumtank verläuft. In diesem Leitungsabschnitt ist gesättigtes superfluides Helium angeordnet.

Die JP H09 79677 A beschreibt ein Gerät zur Erzeugung von suprafluidem Helium, mit einem ausziehbaren Tank für superfluides Helium, wobei der ausziehbare Tank in einem Isolationstank angeordnet ist. Über dem ausziehbaren Tank ist ein Behälter für normalflüssiges Helium angeordnet. Vom Behälter führt eine Leitung über ein Ventil zu einer Helium-Kühlvorrichtung im Inneren des ausziehbaren Tanks.

L.C. Yang et al., Cryogenics, April 1981, pp. 207-212, beschreibt eine Apparatur zur Charakterisierung des Transports von flüssigem Helium. In einem Haupt-Dewar mit suprafluidem Helium (He II) einer Temperatur T1 ist ein kleiner Dewar mit He II einer Temperatur T2 angeordnet. Die Dewar stehen über ein Nadelventil und ein Transferrohr aus Edelstahl in Verbindung.

Aufgabe der Erfindung

Der Erfindung liegt die Aufgabe zugrunde, einen Kryostaten vorzustellen, bei dem eine größere Menge an flüssigem Helium zum Betrieb einer Joule-Thomson-Kühleinheit bevorratet werden kann, ohne dass die Bauhöhe des Kryostaten vergrößert werden muss.

Kurze Beschreibung der Erfindung

Diese Aufgabe wird auf überraschend einfache und wirkungsvolle Weise gelöst durch einen Kryostat, mit

- einem ersten Heliumtank, der in einem unteren Teil mit flüssigem Helium, insbesondere superflüssigem Helium, mit einer Temperatur < 2,5 K und in einem oberen Teil zumindest teilweise mit flüssigem Helium, insbesondere normalflüssigem Helium, mit einer Temperatur > 4 K befüllt ist, derart, dass der erste Heliumtank einen ersten Bereich aufweist, der vom unteren Ende des unteren Teils bis zu einer ersten Flüssigkeitsoberfläche im oberen Teil durchgehend mit flüssigem Helium gefüllt ist,

- mit einer Joule-Thomson-Kühleinheit, mit der das flüssige Helium im unteren Teil des ersten Heliumtanks durch expandierendes Helium über einen Wärmetauscher gekühlt werden kann,

- einem zweiten Heliumtank, der zumindest teilweise mit flüssigem Helium, insbesondere normalflüssigem Helium, mit einer Temperatur > 4 K befüllt ist, derart, dass der zweite Heliumtank einen zweiten Bereich aufweist, der von einem unteren Ende des zweiten Heliumtanks bis zu einer zweiten

Flüssigkeitsoberfläche im zweiten Heliumtank durchgehend mit flüssigem Helium gefüllt ist, wobei der erste Heliumtank und der zweite Heliumtank zumindest unterhalb der Flüssigkeitsoberflächen flüssigkeitsdicht voneinander abgetrennt sind, wobei die Joule-Thomson-Einheit zur Kühlung des unteren Teils des ersten Heliumtanks flüssiges Helium dem zweiten Heliumtank

- direkt über Ansaugen von flüssigem Helium aus dem zweiten Heliumtank,

- oder indirekt über eine Verdampfung von flüssigem Helium aus dem zweiten Heliumtank, Rekondensation des verdampften Heliums in den oberen Teil des ersten Heliumtanks und Ansaugen von flüssigem Helium aus dem ersten Heliumtank,

entziehen kann, und wobei

- zwischen dem oberen und unterem Teil des ersten Heliumtanks eine thermische Barriere angeordnet ist, in der sich ein Temperaturgradient von mindestens 1 Kelvin ausbildet und/oder eine Grenzfläche zwischen superflüssigem Helium und normalflüssigem Helium verläuft, und/oder

- der erste Heliumtank ein Zugangsrohr umfasst, welches enger ist als ein darunter liegender Abschnitt des ersten Heliumtanks, derart, dass sich im Zugangsrohr ein Temperaturgradient von wenigstens 1 Kelvin ausbildet und/oder eine Grenzfläche zwischen superflüssigem Helium und normalflüssigen Helium im Zugangsrohr liegt.

Beim erfindungsgemäßen Kryostaten wird zusätzlich zum ersten Heliumtank ein zweiter Heliumtank zur Verfügung gestellt, der zusätzlich zu dem Vorrat an flüssigem Helium bei einer Temperatur > 4 K im oberen Teil des ersten Heliumtanks einen weiteren Vorrat an flüssigem Helium bei einer Temperatur > 4 K zur Verfügung stellt. Dieser weitere Vorrat kann zur Kühlung des unteren Teils des ersten Heliumtanks, d.h. zur Kühlung des flüssigen Heliums bei einer Temperatur < 2,5 K genutzt werden. Der Kryostat ist also so ausgebildet, dass zur Kühlung des ersten Heliumtanks flüssiges Helium dem zweiten Heliumtank direkt oder indirekt entzogen werden kann.

Der Zugriff auf den zweiten Heliumtank kann durch die Joule-Thomson-Kühleinheit direkt erfolgen, indem das im zweiten Heliumtank enthaltene flüssige Helium in eine typischerweise am Boden des zweiten Heliumtanks mündende Zuführleitung rinnt und so zur Joule-Thomson Kühleinheit bzw. dessen Nadelventil gelangt. Am Nadelventil, das an eine Pumpleitung angeschlossen ist, expandiert das flüssige Helium und kühlt sich dabei ab. Ein Wärmetauscher in der Pumpleitung, der im unteren Teil des ersten Heliumtanks angeordnet ist (bevorzugt oberhalb einer Magnetspule), kühlt das flüssige Helium im unteren Teil des ersten Heliumtanks. Man beachte, dass das Nadelventil hierbei typischerweise außerhalb der beiden Heliumtanks angeordnet ist ("geteilte Anordnung").

Ebenso ist es möglich, dass die Joule-Thomson-Kühleinheit flüssiges Helium aus dem ersten Heliumtank ansaugt bzw. ihrem Nadelventil zuführt. Am Nadelventil, das auch hier an eine Pumpleitung angeschlossen ist, expandiert wiederum das flüssige Helium und kühlt sich dabei ab, und ein Wärmetauscher in der Pumpleitung, der im unteren Teil des ersten Heliumtanks angeordnet ist (bevorzugt oberhalb einer Magnetspule), kühlt das flüssige Helium im unteren Teil des ersten Heliumtanks. Typischerweise wird dabei eine Zuführleitung der Joule-Thomson Kühleinheit in den oberen Teil des ersten Heliumtanks geführt, so dass wärmeres flüssiges Helium > 4 K angesaugt wird. Es ist aber auch möglich, unterkühltes flüssiges Helium < 2,5 K aus dem unteren Teil anzusaugen; in diesem Fall wird der untere Teil des ersten Heliumtanks durch flüssiges Helium aus dem oberen Teil des ersten Heliumtanks (ggf. durch eine thermische Barriere hindurch) aufgefüllt. Der obere Teil des ersten Heliumtanks wird dann durch aus dem zweiten Heliumtank verdampfendes Helium, das in den oberen Teil des ersten Heliumtanks rekondensiert (etwa von einem Teilabschnitt der Pumpleitung in den oberen Teil des Heliumtanks herabtropft) aufgefüllt, bevorzugt sodass die Flüssigkeitsoberfläche im ersten Heliumtank konstant bleibt, solange der weitere Vorrat an flüssigem Helium im zweiten Heliumtank nicht erschöpft ist. Typischerweise ist dafür eine Heliumgas führende Verbindung zwischen einem ersten Gasraum oberhalb der Flüssigkeitsoberfläche des ersten Heliumtanks und einem zweiten Gasraum oberhalb der Flüssigkeitsoberfläche des zweiten Heliumtanks eingerichtet, sodass die beiden Tanks also einen gemeinsamen Gasraum für gasförmiges Helium aufweisen. Es ist aber auch denkbar, lediglich rekondensiertes flüssiges Helium aus dem zweiten Gasraum in den oberen Teil des ersten Heliumtanks zu überführen.

Gemäß der Erfindung sind die unteren, flüssigkeitsführenden Bereiche des ersten Heliumtanks und des zweiten Heliumtanks flüssigkeitsdicht voneinander getrennt. Mit anderen Worten, die Flüssigkeitsräume des ersten und des zweiten Heliumtanks kommunizieren nicht miteinander. Insbesondere besteht keine flüssiges Helium führende Verbindung zwischen dem ersten Bereich des ersten Heliumtanks und dem zweiten Bereich des zweiten Heliumtanks. Bevorzugt sind auch keine durch Ventile abtrennbaren Verbindungen zwischen den Flüssigkeitsräumen der beiden Tanks eingerichtet (dies wäre zum einen technisch schwierig, und zum anderen können die Auswirkungen bei einem Versagen des Ventils oder einem versehentlichen Öffnen katastrophal sein, wenn eine stromführende supraleitende Magnetspule im unteren Teil des ersten Heliumtanks ihr Kühlmittel verliert). Entsprechend sind die Flüssigkeitsspiegel (d.h. die absolute Lage der Flüssigkeitsoberflächen) im ersten Heliumtank und im zweiten Heliumtank voneinander unabhängig. Insbesondere kann im Betrieb der Flüssigkeitsspiegel im zweiten Tank unter den Flüssigkeitsspiegel im ersten Tank sinken.

Dadurch ist es möglich, den zweiten Heliumtank praktisch unabhängig vom ersten Heliumtank im Kryostaten zu platzieren. Der zweite Heliumtank braucht insbesondere nicht auf gleicher Höhe wie der obere Teil des ersten Heliumtanks angeordnet zu werden. Entsprechend kann der zweite Heliumtank so platziert werden, dass die Bauhöhe des Kryostaten nicht verändert wird. Beispielsweise kann der zweite Heliumtank seitlich des ersten Heliumtanks, und insbesondere seitlich des unteren Teils des ersten Heliumtanks, angeordnet werden.

Im unteren Teil des ersten Heliumtanks ist typischerweise eine supraleitende Magnetspule angeordnet. Die Kryostaten-Anordnung kann insbesondere in einer NMR-Apparatur eingesetzt werden. Der zweite Heliumtank ist thermisch zumindest vom unteren Teil des ersten Heliumtanks isoliert, beispielsweise über Vakuumisolation.

Die Flüssigkeitsoberflächen in beiden Tanks haben bevorzugt eine Temperatur von etwa 4 K, was einem Dampfdruck von ca. 1 bar entspricht. In der Praxis wird dieser Druck typischerweise aktiv geregelt, sodass er leicht (typischerweise 10-50 mbar) über Atmosphärendruck (Luftdruck in der Umgebung) liegt. Dadurch können im Fall kleiner Leckagen keine Verunreinigungen in den Kryobehälter eindringen. Wenn der erste und der zweite Heliumtank keine kommunizierenden Gasräume haben, wird der Druck zweimal geregelt, nämlich im ersten und zweiten Heliumtank.

Bei einer ersten, besonders vorteilhaften Alternative des erfindungsgemäßen Kryostaten ist zwischen dem oberen und unteren Teil des ersten Heliumtanks eine thermische Barriere angeordnet, in der sich ein Temperaturgradient von mindestens 1 Kelvin ausbildet und/oder eine Grenzfläche zwischen superflüssigem Helium und normalflüssigem Helium verläuft. Durch die thermische Barriere, die beispielsweise als eine glasfaserverstärkte Kunststoffplatte mit einigen Durchtrittslöchern für flüssiges Helium ausgebildet ist, kann der Wärmeeintrag in den unteren Teil gering gehalten werden, gleichzeitig jedoch ein (typischerweise langsamer) Übertritt von flüssigem Helium vom oberen in den unteren Bereich (und umgekehrt) gestattet werden.

Auf das flüssige Helium im unteren Teil kann durch die thermische Barriere hindurch ein (schwerkraftbedingter) Druck mittels des flüssigen Helium im oberen Teil ausgeübt werden, wodurch das flüssige Helium im unteren Teil (bezüglich des He-Dampfdrucks über dem oberen Teil) unterkühlt werden kann. Man beachte, dass sich durch den Ort einer Grenzfläche zwischen superflüssigem und normalflüssigem Helium innerhalb der thermischen Barriere der Isolationsgrad des unteren Teils vom oberen Teil einstellen lässt bzw. dieser sich selbst regeln kann.

Vorteilhaft ist auch eine zweite Alternative des erfindungsgemäßen Kryostaten, bei der der erste Heliumtank ein Zugangsrohr umfasst, welches enger ist als ein darunter liegender Abschnitt des ersten Heliumtanks, derart, dass sich im Zugangsrohr ein Temperaturgradient von wenigstens 1 Kelvin ausbildet und/oder eine Grenzfläche zwischen superflüssigem Helium und normalflüssigem Helium im Zugangsrohr liegt. Im Zugangsrohr liegt dann auch die Grenze zwischen oberem Teil und unterem Teil des ersten Heliumtanks. Im verengten Zugangsrohr kann ein Wärmeaustausch nur über eine kleine Querschnittsfläche im Vergleich zur Querschnittsfläche des darunter liegenden Abschnitts stattfinden, was eine isolierende Wirkung für den unteren Teil des ersten Heliumtanks hat. Entsprechend kann in dieser Alternative auf eine thermische Barriere verzichtet werden, falls gewünscht. Typischerweise ist die (horizontale) Querschnittsfläche im verengten Zugangsrohr maximal 1/10, bevorzugt maximal 1/20, so groß wie die Querschnittsfläche des darunter liegenden Abschnitts.

Bevorzugte Varianten der Erfindung

Bei einer bevorzugten Ausführungsform des erfindungsgemäßen Kryostaten ist der zweite Heliumtank zumindest teilweise seitlich neben dem ersten Heliumtank und/oder zumindest teilweise um den ersten Heliumtank herum angeordnet. Insbesondere kann der zweite Heliumtank ganz oder teilweise neben dem unteren Teil des ersten Heliumtanks und/oder um den unteren Teil des ersten Heliumtanks herum angeordnet sein. Bei Anordnung des zweiten Heliumtanks horizontal neben dem ersten Heliumtank oder um diesen herum wird die Bauhöhe des Kryostaten nicht vergrößert; insgesamt kann ein kompakter Kryostatenaufbau erreicht werden.

Besonders vorteilhaft ist eine Ausführungsform, bei der der erste Heliumtank und der zweite Heliumtank so angeordnet sind, dass die erste Flüssigkeitsoberfläche des flüssigen Heliums im ersten Heliumtank höher liegen kann als die zweite Flüssigkeitsoberfläche des flüssigen Heliums im zweiten Heliumtank, insbesondere wobei die erste Flüssigkeitsoberfläche des flüssigen Heliums im ersten Heliumtank höher liegt als die zweite Flüssigkeitsoberfläche des flüssigen Heliums im zweiten Heliumtank. In diesem Fall kann Raum tiefer gelegen als der obere Teils des ersten Heliumtanks für die Bevorratung von flüssigem Helium von > 4 K mit dem zweiten Heliumtank genutzt werden. Insbesondere kann der Flüssigkeitsspiegel im zweiten Heliumtank ("Vorratstank") unter das Niveau der Spulenoberkante im ersten Heliumtank fallen, was bei Kryostaten des Standes der Technik nicht möglich ist.

Bevorzugt ist auch eine Ausführungsform, bei der das Fassungsvermögen des zweiten Heliumtanks für flüssiges Helium wenigstens 3 mal größer ist als das des oberen Teils des ersten Heliumtanks. In diesem Fall kann der Vorrat an flüssigem Helium, mit dem der Betrieb der Joule-Thomson-Kühleinheit aufrecht erhalten werden kann, besonders stark vergrößert werden. Entsprechend können besonders lange Intervalle zur Nachfüllung von flüssigem Helium oder besonders lange Ausfallzeiten einer (gegenüber der Joule-Thomson-Kühleinheit) zusätzlichen aktiven Kühleinrichtung (etwa einem Pulsrohrkühler) eingerichtet werden.

Eine bevorzugte Ausführungsform des Kryostaten sieht vor, dass er eine vertikale Raumtemperaturbohrung umfasst, wobei der erste Heliumtank um die Raumtemperaturbohrung herum und der zweite Heliumtank um den ersten Heliumtank herum angeordnet ist. Diese Bauform ist besonders platzsparend und in der Praxis bewährt. Wegen der typischerweise vorgesehenen Einführung einer Shimvorrichtung von oben in die Raumtemperaturbohrung ist hier ein oberer Teil des ersten Heliumtanks mit geringer Höhe besonders vorteilhaft, da die Shimvorrichtung nochmals freien Raum oberhalb des Kryostaten entsprechend dieser Höhe als Einführraum benötigt. Für die hochauflösende NMR-Spektroskopie wählt man oft eine vertikale Bohrung; meist werden hierbei flüssige Proben untersucht, die sich leicht über die vertikale Bohrung einführen lassen.

Bei einer alternativen Ausführungsform des Kryostaten umfasst er eine horizontale Raumtemperaturbohrung, wobei der zweite Heliumtank horizontal neben dem ersten Heliumtank angeordnet ist, insbesondere wobei die Raumtemperaturbohrung sowohl den ersten Heliumtank als auch den zweiten Heliumtank durchragt. Diese Bauform ist für besonders niedrige Deckenhöhen von Laborräumen geeignet, insbesondere da eine Shimvorrichtung von der Seite eingeführt werden kann. Horizontale Bohrungen werden typischerweise bei bildgebenden Verfahren in der Medizin und Forschung verwendet; die typischen Versuchsobjekte wie Menschen, Mäuse, Ratten, etc. lassen sich besonders leicht in horizontale Bohrungen einführen.

Besonders bevorzugt ist eine Ausführungsform, bei der die Joule-Thomson-Kühleinheit flüssiges Helium direkt aus dem zweiten Heliumtank ansaugt, insbesondere an einem unteren Ende des zweiten Heliumtanks. Diese Bauform ist relativ einfach, insbesondere weil keine besondere Verdampfung, Konvektion und Rekondensation von Heliumgas eingerichtet zu werden braucht. In dieser Ausführungsform wird kein gemeinsamer Gasraum des ersten und zweiten Heliumtanks benötigt; er kann aber dennoch eingerichtet sein, falls gewünscht. Der zweite Tank hat an seiner Unterseite einen Auslass, durch den flüssiges Helium in das Ventil (Nadelventil) der Joule-Thomson-Kühleinheit strömt, typischerweise über eine Zuführleitung. Die Zuführleitung wird ausreichend lange gewählt, sodass die Temperaturniveaus von zweitem Heliumtank (ca. 4.2 K) und J-T-Einheit (< 2.5 K) ausreichend voneinander isoliert sind. Im Ventil verdampft das Helium, und der kalte Dampf wird durch einen Wärmetauscher durch den unteren Bereich des ersten Heliumtanks geleitet und kühlt diesen.

Bevorzugt ist auch eine Ausführungsform, bei der ein erster Gasraum des ersten Heliumtanks und ein zweiter Gasraum des zweiten Heliumtanks Heliumgas führend miteinander verbunden sind. Durch den ersten Gasraum (oberhalb der ersten Flüssigkeitsoberfläche), den zweiten Gasraum (oberhalb der zweiten Flüssigkeitsoberfläche) und allen etwaigen Heliumgas führenden Verbindungsabschnitten des Kryostaten wird im Kryostaten ein gemeinsamer Gasraum über den Heliumtanks eingerichtet. Kaltes Heliumgas kann unter normalen Betriebsbedingungen vom zweiten Heliumtank in den ersten Heliumtank strömen und dort kondensieren. Bei dieser Ausführungsform kann daher die Joule-Thomson-Kühleinheit flüssiges Helium aus dem ersten Heliumtank, typischerweise aus dem oberen Teil, oder auch aus dem unteren Teil, ansaugen. In dieser Ausführungsform reicht es aus, den Druck nur an einer Stelle zu regeln - typischerweise mittels eines Heizers. Der Heizer wird bevorzugt im zweiten Tank angeordnet. Helium, das dort verdampft, kann dann im ersten Tank kondensieren.

Bei einer vorteilhaften Weiterbildung dieser Ausführungsform ist eine Heliumflussrate an der Joule-Thomson-Kühleinheit, welche flüssiges Helium aus dem ersten Heliumtank ansaugt, so gewählt, dass bei den gegebenen Wärmelasten auf den ersten und zweiten Heliumtank entsprechend der besagten Heliumflussrate flüssiges Helium aus dem zweiten Heliumtank verdampft und in den oberen Teil des ersten Heliumtanks rekondensiert. In anderen Worten, der Flüssigkeitsspiegel im ersten Tank ändert sich nicht. Dieses Prinzip ist deshalb möglich, weil bei der Entspannung von Helium von ca. 1 bar auf ca. 10 mbar (der typische Druck hinter dem Ventil der Joule-Thomson-Kühleinheit) mehr Kühlleistung frei wird, als die Kondensation bei konstantem Druck (von ca. 1 bar) benötigt. Die Differenz steht dann für die Absorption externer Wärmelasten zu Verfügung.

Bei einer anderen Weiterbildung der obigen Ausführungsform ist vorgesehen, dass der obere Teil des ersten Heliumtanks und der zweite Heliumtank durch eine Wandung getrennt sind, an deren oberen Ende eine Überlaufkante ausgebildet ist, über die flüssiges Helium vom ersten Heliumtank in den zweiten Heliumtank überlaufen kann. Bei dieser Bauform kann die Rekondensation auf den oberen Teil des ersten Heliumtank fokussiert werden, was baulich einfach einzurichten ist, und der zweite Heliumtank wird durch Überlauf des ersten Heliumtanks (nach-)gefüllt. Die Wandung ist typischerweise Teil einer Vakuumisolation.

Besonders bevorzugt ist eine Ausführungsform des Kryostaten, bei der er eine aktive Kühleinrichtung, insbesondere einen Pulsrohrkühler, umfasst, mit der aus dem ersten Heliumtank und/oder aus dem zweiten Heliumtank verdampftes Helium verflüssigt werden kann. Mit der (zur Joule-Thomson-Kühleinrichtung zusätzlichen) aktiven Kühleinrichtung kann verdampftes oder von außerhalb des Kryostaten eingeführtes oder von der Joule-Thomson-Kühleinheit expandiertes und nun zurückgeführtes gasförmiges Helium verflüssigt werden; insbesondere kann der Kryostat mit einem geschlossenen Heliumkreislauf (also im Normalbetrieb ohne Heliumverlust) betrieben werden. Das verflüssigte Helium steht für den Betrieb der Joule-Thomson-Kühleinheit (wieder) zur Verfügung. Falls ein gemeinsamer Gasraum der beiden Heliumtanks eingerichtet ist, verflüssigt die Kühleinrichtung das Heliumgas bevorzugt in diesem gemeinsamen Gasraum. Falls der erste und zweite Heliumtank getrennte (gegeneinander abgedichtete) Gasräume aufweisen, wird typischerweise das Heliumgas im Gasraum des zweiten Heliumtanks verflüssigt. Typischerweise verflüssigt sich das Heliumgas an einer Kühlstufe der Kühleinrichtung, von der es in den ersten Heliumtank oder den zweiten Heliumtank herabtropft.

Bevorzugt ist dabei vorgesehen, dass die aktive Kühleinrichtung so im Kryostaten angeordnet ist, dass bei Ausfall der Kühleinrichtung eine Wärmelast zu einem größeren Anteil in den zweiten Heliumtank eingebracht wird als in den ersten Heliumtank, so dass bei Ausfall der Kühleinrichtung mehr Helium aus dem zweiten Heliumtank verdampft als aus dem ersten Heliumtank. Dadurch wird ein Freilegen der supraleitenden Magnetspule, und damit deren Quench, im unteren Teil des Heliumtanks verzögert. Um die Verdampfung von Helium aus dem ersten Heliumtank zu verringern, kann auch eine gut wärmeteilende Verbindung (etwa ein Metallgestänge, bevorzugt aus Kupfer) von einem wärmeeinbringenden Element in den zweiten Bereich im zweiten Heliumtank vorgesehen sein.

Vorteilhafter Weise kann hierfür vorgesehen sein, dass die Kühleinrichtung oberhalb des zweiten Heliumtanks angeordnet ist, und die erste Flüssigkeitsoberfläche vollständig oder überwiegend abgeschattet ist, insbesondere durch eine zur Vakuumisolation des Kryostaten gehörende Wandung. Dadurch wird Wärmestrahlung vor allem in die unter der Kühleinrichtung liegende zweite Flüssigkeitsoberfläche im zweiten Tank eingebracht, und nicht in die erste Flüssigkeitsoberfläche. Dies ist baulich relativ einfach einzurichten.

Vorteilhaft ist eine Ausführungsform des erfindungsgemäßen Kryostaten, bei der eine Pumpleitung der Joule-Thomsen-Kühleinheit durch den oberen Teil des ersten Heliumtanks und dann zumindest mit einem Teilabschnitt in einem Gasraum oberhalb des ersten Heliumtanks verläuft, so dass an der Außenseite der Pumpleitung in dem Teilabschnitt verflüssigtes Helium von der Pumpleitung in den oberen Teil des ersten Heliumtank tropfen kann. Dadurch kann auf einfache Weise das flüssige Helium im oberen Teil des ersten Heliumtanks aufgefüllt werden. Falls die Gasräume des ersten Heliumtanks und des zweiten Heliumtanks voneinander getrennt sind, wird bevorzugt die Pumpleitung zuerst mit einem Teilabschnitt im Gasraum des ersten Heliumtanks geführt, und dann mit einem weiteren Teilabschnitt im Gasraum des zweiten Heliumtanks geführt.

Bevorzugt ist eine Weiterbildung hierzu, bei der die Pumpleitung im oberen Teil des ersten Heliumtanks und/oder in dem Teilabschnitt wendelförmig oder mit Wärmetauscherrippen ausgebildet ist. Dadurch kann die Verflüssigungsrate vergrößert werden.

Bei einer vorteilhaften Ausführungsform ist vorgesehen, dass für das erstmalige Befüllen mit Helium ausgehend von einem Halsrohr des Kryostaten eine erste Verrohrung in einen unteren Abschnitt des ersten Heliumtanks und eine zweite Verrohrung in einen unteren Abschnitt des zweiten Heliumtanks reicht. Dadurch kann die Befüllung des Kryostaten auf besonders effiziente Weise erfolgen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1      eine schematische Querschnittsdarstellung einer ersten Ausführungsform eines erfindungsgemäßen Kryostaten, mit im ersten Heliumtank saugender Joule-Thomson-Kühleinheit und gemeinsamem Gasraum der beiden Heliumtanks;

Fig. 2      eine schematische Querschnittsdarstellung einer zweiten Ausführungsform eines erfindungsgemäßen Kryostaten, mit am zweiten Heliumtank saugender Joule-Thomson-Kühleinheit und getrennten Gasräumen der beiden Heliumtanks;

Fig. 3      eine schematische Querschnittsdarstellung einer dritten Ausführungsform eines erfindungsgemäßen Kryostaten, mit am zweiten Heliumtank saugender Joule-Thomson-Kühleinheit und gemeinsamem Gasraum der beiden Heliumtanks;

Fig. 4      eine schematische Querschnittsdarstellung einer vierten Ausführungsform eines erfindungsgemäßen Kryostaten, mit zwei Verrohrungen mit separaten Einfülltrichtern zur Befüllung der Heliumtanks;

Fig. 5      eine schematische Querschnittsdarstellung einer fünften Ausführungsform eines erfindungsgemäßen Kryostaten, mit zwei Verrohrungen zur Befüllung der Heliumtanks mit gemeinsamer Kopplungsstation für einen drehbarem Transferstab;

Fig. 6      eine schematische Querschnittsdarstellung einer sechsten Ausführungsform eines erfindungsgemäßen Kryostaten, mit aktiver Kühleinrichtung über dem zweiten Heliumtank;

Fig. 7      eine schematische Querschnittsdarstellung einer siebtem Ausführungsform eines erfindungsgemäßen Kryostaten, mit einem ersten Heliumtank mit verengtem Zugangsrohr;

Fig. 8      eine schematische Querschnittsdarstellung einer achten Ausführungsform eines erfindungsgemäßen Kryostaten, mit horizontaler Raumtemperaturbohrung.

*Überblick über die Erfindung*

Der Bauhöhe eines Magnetsystems, das eine oder mehrere Magnetspulen in einem Kryostaten umfasst und zum Beispiel für NMR-Messungen in einer Raumtemperaturbohrung des Kryostaten eingesetzt werden soll, sind in der Praxis Grenzen gesetzt, insbesondere durch die beim Anwender verfügbare Raumhöhe (Deckenhöhe). Entsprechend kann ein im Magnetsystem befindlicher Heliumtank nicht beliebig groß ausgeführt werden. Damit sind der Haltezeit des Systems ebenfalls Grenzen gesetzt. Die vorliegende Erfindung beschreibt zwei Konzepte, wie diese Limitierung der Haltezeit umgangen werden kann. Ebenso können die erfindungsgemäßen Konzepte dazu verwendet werden, um bei gleicher Haltezeit eine Bauhöhenreduktion zu erreichen.

Beiden Konzepten ist gemeinsam, dass flüssiges Helium von > 4 K nicht nur in einem oberen Teil eines ersten Heliumtanks, in welchem in einem unteren Teil unterkühltes Helium von < 2,5 enthalten ist, sondern auch in einem zweiten Heliumtank bevorratet ist, wobei dieser weitere Vorrat für die Kühlung des unterkühlten Heliums von < 2,5 K von einer Joule-Thomson-Kühleinheit genutzt werden kann.

*Erstes Konzept mit Abpumpen im ersten Heliumtank*

Im Rahmen des ersten erfindungsgemäßen Konzepts ist typischerweise vorgesehen, (normal-)flüssiges Helium bei hier ca. 4.2 K in zwei Tanks zu lagern, nämlich im oberen Bereich eines ersten ("inneren") Heliumtanks und in einem zweiten ("äußeren") Heliumtank. Der zweite Heliumtank ist um den ersten Heliumtank herum angeordnet, sodass die Bauhöhe des Systems durch den zweiten Tank nicht vergrößert wird (allerdings wächst der Durchmesser des Systems leicht). Der zweite Tank ist so dimensioniert, dass das in ihm zu Verfügung stehende Helium die Haltezeit des Systems deutlich vergrößert. Da die Gasräume der beiden Tanks miteinander verbunden sind, kann Helium, das im zweiten Tank verdampft, im ersten Tank rekondensieren. Dadurch wird die Notwendigkeit eliminiert, Helium aktiv von einem Tank in den anderen zu befördern (z.B. durch Pumpen).

*Zum Wärmefluss im Rahmen des ersten Konzepts*

Der erste Tank ist so ausgeführt, dass sich zwischen seinem unteren und oberen Bereich ein großer Temperaturgradient ausbilden kann. Im Besonderen kann das durch Einziehen einer "thermischen Barriere" erreicht werden, deren thermische Isolationseigenschaften so gut sind, dass das Helium im unteren Bereich (unteren Teil) des ersten Tanks den superfluiden (superflüssigen) Zustand erreichen kann. Die Phasengrenze zwischen normal- und superfluider Komponente liegt dann innerhalb der thermischen Barriere.

In einem NMR Magnetsystem wird die Wärmelast auf den unteren Bereich des ersten Tanks typischerweise durch Wärmestrahlung vom 80 K Schild (Strahlungsschild) in der zentralen Bohrung dominiert. Im Folgenden wird diese Wärmelast $Q_{2K}$ genannt. Wärme wird dem unteren Bereich des ersten Tanks von einer Joule-Thomson (J-T) Kühleinheit entzogen. Die zu Verfügung stehende Kühlleistung wird im Folgenden $Q_{JT}$ genannt. Im thermischen Gleichgewicht darf $Q_{JT}$ nicht kleiner sein als $Q_{2K}$.

Die Phasengrenze zwischen normal- und superfluidem Helium verschiebt sich von selbst innerhalb der thermischen Barriere, und zwar so, dass die Differenz zwischen $Q_{JT}$ und $Q_{2K}$ genau ausgeglichen wird und die Temperatur im unteren Bereich des ersten Tanks konstant bleibt. Der über die thermische Barriere fließende Wärmestrom $Q_{TB}$ beträgt

$$Q_{TB} = Q_{JT} - Q_{2K}.$$

Der Heliumstrom durch die J-T Kühleinheit wird typischerweise in ml/h gemessen, wobei sich die Einheit "Milliliter" auf flüssiges Helium bei 4.2 K und Atmosphärendruck bezieht (an diesem Punkt beträgt die Dichte von flüssigem Helium 125.32 kg/m³). Die Enthalpie von flüssigem Helium beträgt -0.1622 kJ/kg bei 4.2 K und Atmosphärendruck, und 16.357 kJ/kg für gasförmiges Helium bei 2.17 K und einem Druck von 10 mbar. Für jeden Milliliter flüssigen Heliums, der durch die J-T Kühleinheit gesaugt wird, wird demnach eine Kühlleistung von 2.07 J generiert, d.h. $Q_{JT}$ = 2.07 J/ml.

Die Wärmelast auf den oberen Bereich (oberen Teil) des ersten Tanks wird im Folgenden $Q_{4Ki}$ genannt. Es wird angenommen, dass diese Wärmelast teilweise von Wärmestrahlung vom Zentralrohr (Raumtemperaturbohrung) auf den oberen Bereich des ersten Tanks, von Wärmestrahlung vom thermischen Schild auf den oberen Bereich des ersten Tanks, und von Wärmeleitung über die Halsrohre verursacht wird. Wärme fließt über die thermische Barriere vom oberen Bereich des ersten Tanks in den unteren Bereich des ersten Tanks. Außerdem fließt Wärme vom oberen Bereich des ersten Tanks in das Rohr (Pumpleitung), durch das Helium von der J-T Kühleinheit abgepumpt wird (darin befindet sich kaltes Heliumgas).

Die Kühlleistung $Q_{PL}$, die in dieser Abpumpleitung zu Verfügung steht, entspricht der Enthalpiedifferenz von gasförmigem Helium (10 mbar) bei 4.2 K und bei 2.17 K. Die zwei Enthalpiewerte betragen 26.973 kJ/kg und 16.357 kJ/kg, d.h. die zusätzlich verfügbare Kühlleistung beträgt 10.616 kJ/kg oder $Q_{PL}$ = 1.33 J/ml.

Wenn die Nettowärmelast auf den oberen Bereich des ersten Tanks positiv ist, verdampft Helium. Wenn die Nettowärmelast negativ ist, kann Helium, das vom zweiten Tank verdampft, im ersten Tank rekondensiert werden. Die latente Wärme $L$ von Helium bei Atmosphärendruck und 4.2 K beträgt 20.9172 kJ/kg oder $L$ = 2.621 J/ml.

Mit den Durchflüssen $\dot{n}_{JT}$ (durch die J-T Kühleinheit) und $\dot{n}_{I-O}$ (vom zweiten Tank in den ersten Tank durch Verdampfen/Rekondensation) kann die folgende Wärmebilanz für den ersten Tank angeschrieben werden:

$$\dot{n}_{I-O} \cdot L = \dot{n}_{JT} \cdot \left(Q_{JT} + Q_{PL}\right) - \left(Q_{2K} + Q_{4Ki}\right).$$

Im Normalbetrieb soll der Heliumfüllstand im ersten Tank unverändert bleiben, d.h.. $\dot{n}_{I-O} = \dot{n}_{JT}$. Der Durchfluss beträgt dann

$$\dot{n}_{JT} = \frac{Q_{2K} + Q_{4Ki}}{Q_{JT} + Q_{PL} - L} = \frac{Q_{2K} + Q_{4Ki}}{0.779 \text{ J/ml}}$$

Für eine typische Wärmelast $Q_{2K} + Q_{4Ki}$ = 250 mW wäre also ein Durchfluss von 1155 ml/h erforderlich.

Um den nötigen Durchfluss auf einen niedrigeren Wert von etwa 250 ml/h zu reduzieren, muss der Kryostat so konstruiert werden, dass die Gesamtwärmelast auf den ersten Heliumtank (sowohl auf den oberen als auch auf den unteren Bereich) 54 mW nicht überschreitet, d.h. der Großteil der Wärmelast auf die Kaltstufen des Kryostaten muss in den zweiten Heliumtank abgeleitet werden.

*Beschreibung einer Ausführungsform zum ersten Konzept*

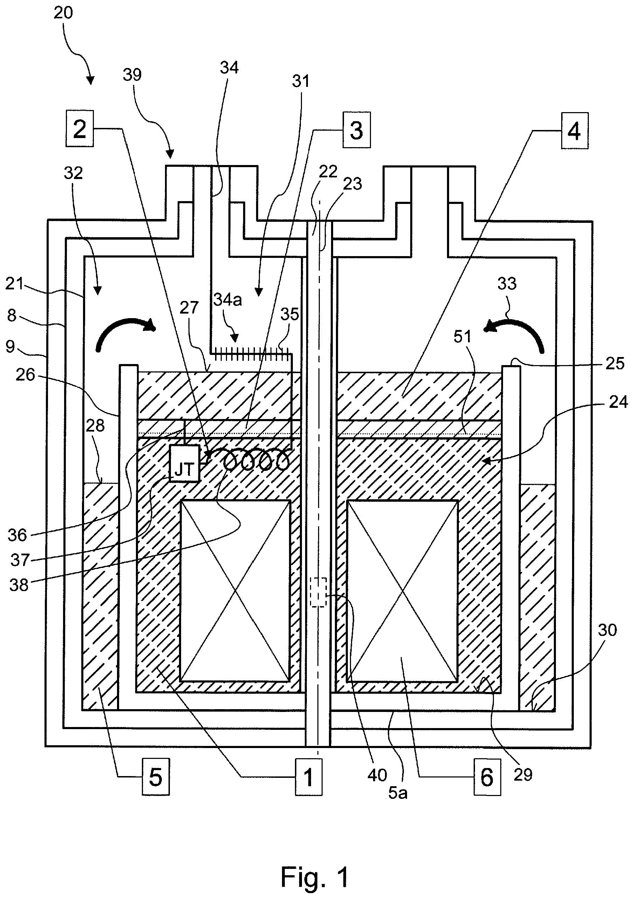

Eine erste Ausführungsform des erfindungsgemäßen Kryostaten wird anhand von **Fig. 1** im Folgenden beispielhaft näher erläutert.

Der Kryostat 20 ist hier nach außen hin durch eine Vakuumbehälterwand 9 begrenzt und weist zwischen der Vakuumbehälterwand 9 und einer Innenwand 21 einen Strahlungsschild 8 auf, der im Vakuum angeordnet ist; man beachte, dass in der Praxis auch zwei oder noch mehr Strahlungsschilde vorgesehen sein können. Der Strahlungsschild 8 kann durch flüssigen Stickstoff (typischerweise bei ca. 80 K) gekühlt werden (nicht näher dargestellt). Der Kryostat 20 weist eine vertikale Raumtemperaturbohrung 22 auf. Der Kryostat 20 ist hier im Wesentlichen rotationssymmetrisch um die Raumtemperaturbohrung 22 herum ausgebildet, vgl. hierzu auch die zentrale, vertikale Achse 23.

Im Inneren des Kryostaten 20 ist ein erster Heliumtank 24 ausgebildet, der in einem unteren Teil 1 mit hier superflüssigem Helium (eng schraffiert dargestellt) bei einer Temperatur von ca. 2,2 K gefüllt ist. In einem oberen Teil 4 des ersten Heliumtanks 24 ist hier normalflüssiges Helium (weit schraffiert) bei einer Temperatur von ca. 4,2 K angeordnet; der obere Teil 4 ist fast vollständig, nämlich bis knapp unter eine Überlaufkante 25 befüllt. Der obere Teil 4 und der untere Teil 1 werden durch eine flüssigkeitsdurchlässige thermische Barriere 3, hier ausgebildet durch eine glasfaserverstärkte Kunststoffplatte mit einigen vertikalen Bohrungen, voneinander getrennt. In der thermischen Barriere 3, hier nahe von deren unterer Kante, verläuft eine Grenzfläche 51 (gepunktet dargestellt in Fig. 1) zwischen dem superflüssigen Helium und dem normalflüssigen Helium. Man beachte, dass sich innerhalb des oberen Teils 4 und innerhalb der thermischen Barriere 3 Temperaturgradienten im flüssigen Helium einstellen können, bedingt durch die temperaturabhängige Dichte von flüssigem Helium.

Im Inneren des Kryostaten 20 ist weiterhin ein zweiter Heliumtank 5 vorgesehen, der hier ebenfalls mit normalflüssigem Helium bei einer Temperatur von ca. 4,2 K befüllt ist. Der zweite Heliumtank 5 ist hier zu ca. 2/3 befüllt. Der zweite Heliumtank 5 ist um den ersten Heliumtank 24 herum angeordnet und erstreckt sich hier in vertikaler Richtung sowohl über den unteren Teil 1 als auch über den oberen Teil 4 des ersten Heliumtanks 24.

Der zweite Heliumtank 5 ist durch eine über ihre gesamte Höhe flüssigkeitsdichte Wandung 26 vom ersten Heliumtank 24 abgetrennt. Daher kann auch die erste Flüssigkeitsoberfläche 27 im ersten Heliumtank 24 deutlich oberhalb der zweiten Flüssigkeitsoberfläche 28 im zweiten Heliumtank 5 liegen. Man beachte, dass hier auch das untere Ende 29 des ersten Heliumtanks 24 etwas über dem Niveau des unteren Endes 30 des zweiten Heliumtanks 5 liegt. Am zweiten Heliumtank 5 kann dann leicht eine Platte 5a montiert werden, mit der thermische Strahlung vom Strahlungsschild 8 abgefangen wird, bevor sie auf den ersten Heliumtank 24 trifft.

Ein erster Gasraum 31 für Heliumgas des ersten Heliumtanks 24, oberhalb der ersten Flüssigkeitsoberfläche 27, und ein zweiter Gasraum 32 für Heliumgas des zweiten Heliumbehälters 5, oberhalb der zweiten Flüssigkeitsoberfläche 28, sind oberhalb der Überlaufkante 25 miteinander verbunden, so dass ein gemeinsamer Gasraum im Kryostaten 20 eingerichtet ist. Dadurch ist eine Verdampfung von flüssigem Helium aus dem zweiten Heliumtank 5 in den gemeinsamen Gasraum und eine Rekondensation des Heliums in den oberen Teil 4 des ersten Heliumtanks 24 möglich, vgl. die den Transport über die Gasphase andeutenden Pfeile 33. Die Rekondensation findet hier direkt an der Flüssigkeitsoberfläche 27 oder an einem Teilabschnitt 34a einer kalten Pumpleitung 34 statt, die in dem Teilabschnitt 34a mit Wärmetauscherrippen 35 ausgestattet ist. Vom Teilabschnitt 34a tropft rekondensiertes Helium in den oberen Teil 4 hinein. Falls zu viel Helium in den oberen Teil 4 gelangt, kann flüssiges Helium über die Überlaufkante 25 in den zweiten Heliumtank 5 abfließen. Der Gasdruck in gemeinsamen Gasraum wird geregelt, etwa über einen Gasdrucksensor und einen elektrischen Heizer (nicht dargestellt), typischerweise auf einen Druck knapp (meist 10-50 mbar) über dem umgebenden Atmosphärendruck.

Die Pumpleitung 34 gehört zu einer Joule-Thomson-Kühleinheit 2, mit der das superflüssige Helium im unteren Teil 1 gekühlt wird. Die Joule-Thomson-Kühleinheit 2 umfasst hier eine Zuführleitung 36, die in den oberen Teil 4 des ersten Heliumtanks 24 führt, um von dort flüssiges Helium anzusaugen bzw. flüssiges Helium in die Zuführleitung 36 rinnen zu lassen (man beachte, dass alternativ auch eine Ansaugung von superflüssigem Helium aus dem unteren Teil 1 möglich ist; in diesem Fall kann die Zuführleitung 36 einfach entfallen). In einem Nadelventil 37 wird das flüssige Helium expandiert, wobei es sich stark abkühlt. Zu diesem Zweck liegt an dem Nadelventil 37 ein Unterdruck (meist ca. 10 mbar) über die Pumpleitung 34 an. In die Pumpleitung 34 integriert ist ein Wärmetauscher 38, der hier wendelförmig ausgebildet ist und bevorzugt oberhalb einer Magnetspule 6 angeordnet ist, und einen guten Übergang der Kühlleistung in den unteren Teil 1 sicherstellt. Die Pumpleitung 34 führt durch die thermische Barriere 3, den oberen Teil 4 und den ersten Gasraum 31, und hier weiterhin durch ein Halsrohr 39 aus dem Kryostaten 20 hinaus zu einer Pumpe (nicht dargestellt). Das Nadelventil 37 kann mit einem weiteren Gestänge (nicht dargestellt) im ersten Heliumtank 24 gehalten werden, falls erforderlich.

Im unteren Teil 1 des ersten Heliumtanks 24 ist die supraleitende Magnetspule 6 angeordnet, mit der in der Raumtemperaturbohrung 22 an einer Probenposition für eine zu untersuchende Probe 40 ein starkes homogenes Magnetfeld erzeugt wird, um die Probe 40 hier mit NMR-Spektroskopie und/oder bildgebender NMR zu untersuchen.

*Zweites Konzept mit Abpumpen vom zweiten Tank*

Als Alternative kann der Einlass der J-T Kühleinheit so angeordnet werden, dass Helium aus dem zweiten Tank angesaugt wird. Die J-T Kühleinheit wird idealerweise unterhalb des zweiten Tanks angeordnet, um zu vermeiden, dass der Flüssigkeitsspiegel im zweiten Tank unter das Niveau der J-T Kühleinheit fällt (da es sich um eine kochende Flüssigkeit handelt, würde sich im Saugrohr (Zuführleitung) dann nämlich Gas bilden, was die Funktion der J-T Kühleinheit empfindlich stören würde). Alternativ kann die J-T Kühleinheit z.B. auch im Bodenbereich des ersten Tanks angeordnet sein.

Der untere Bereich (untere Teil) des ersten Tanks wird vom kalten Gas gekühlt, das die J-T Kühleinheit verlässt. Die Verrohrung zwischen dem zweiten Tank und der J-T Kühleinheit muss so ausgeführt werden, dass eine ausreichende thermische Isolation gegeben ist. Der Kryostat sollte außerdem so ausgeführt werden, dass das Nadelventil leicht von oben zugänglich ist, d.h. ein Zugang sollte so gelegt werden, dass die Magnetspule nicht den Weg zwischen der Zugangsöffnung am oberen Ende des Kryostaten und der Kühleinheit versperrt.

*Beschreibung von Ausführungsformen zum zweiten Konzept*

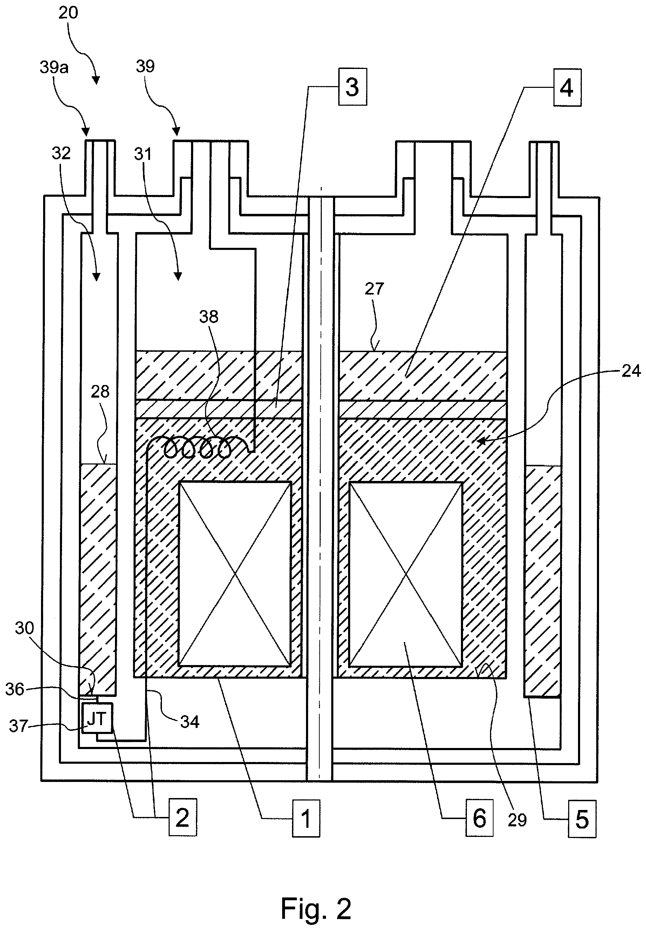

Anhand von **Fig. 2** wird nun eine zweite Ausführungsform eines erfindungsgemäßen Kryostaten 20 beispielhaft vorgestellt. Die zweite Ausführungsform ähnelt der ersten Ausführungsform von Fig. 1 in vielen Aspekten, so dass im Folgenden nur die wesentlichen Unterschiede diskutiert werden (was auch entsprechend für die nachfolgenden Ausführungsformen gilt).

Im Inneren des Kryostaten von Fig. 2 ist wiederum ein erster Heliumtank 24 mit einem unterem Teil 1, gefüllt mit superflüssigem Helium bei ca. 2,2 K, und mit einem oberen Teil 4, teilweise gefüllt mit normalflüssigem Helium bei ca. 4,2 K, vorgesehen. Der obere Teil 4 und der untere Teil 1 sind über eine thermische Barriere 3 getrennt; die Befüllung des ersten Heliumtanks 24 mit flüssigem Helium ist durchgehend vom unteren Ende 29 bis zur ersten Flüssigkeitsoberfläche 27. Ebenso ist ein zweiter Heliumtank 24, teilweise gefüllt mit normalflüssigem Helium bei ca. 4,2 K, vorgesehen, der den ersten Heliumtank 24 ringförmig umschließt. Der erste Heliumtank 24 und der zweite Heliumtank 5 sind hier nicht nur unterhalb der ersten und zweiten Flüssigkeitsoberflächen 27, 28 voneinander flüssigkeitsdicht abgetrennt, sondern die beiden Heliumtanks 24, 5 sind vollständig gegeneinander abgedichtet. Insbesondere sind ein erster Gasraum 31 des ersten Heliumtanks 24, oberhalb der ersten Flüssigkeitsoberfläche 27, und ein zweiter Gasraum 32 des zweiten Heliumtanks 5, oberhalb der zweiten Flüssigkeitsoberfläche 28, auch dicht für Heliumgas voneinander getrennt. Der Gasdruck in den Gasräumen 31, 32 wird jeweils separat geregelt, etwa über Gasdrucksensoren und elektrische Heizer (nicht dargestellt), typischerweise auf einen Druck knapp (meist 10-50 mbar) über dem umgebenden Atmosphärendruck.

Mit einer Joule-Thomson-Kühleinheit 2 kann der untere Teil 1 des ersten Heliumtanks 24 gekühlt werden. Die Kühleinheit 2 umfasst hier ein Nadelventil 37, das unter dem Niveau des unteren Endes 30 des zweiten Heliumtanks 5 angeordnet ist und über eine Zuführleitung 36 mit dem zweiten Heliumtank 5 an seinem unteren Ende 30 verbunden ist. Die Länge der Zuführleitung 36 ist lange genug gewählt, um eine ausreichende thermische Isolation vom zweitem Heliumtank 5 sicherzustellen. Flüssiges Helium aus dem zweiten Heliumtank 5 kann daher in das Nadelventil 37 rinnen, solange der zweite Heliumtank 5 nicht vollständig erschöpft ist, und dort unter Kälteentwicklung expandiert werden. Vom Nadelventil 37 führt eine Pumpleitung 34 in den unteren Teil 1 des ersten Heliumtanks 24, wo die Pumpleitung 34 mit einem Wärmetauscher 38 ausgebildet ist. Die Pumpleitung 34 führt dann durch den oberen Teil 4 des ersten Heliumtanks 24 und hier das Halsrohr 39 aus dem Kryostaten 20 heraus zu einer Pumpe (nicht dargestellt), die für einen Unterdruck in der Pumpleitung (um 10 mbar) sorgt. Das Nadelventil 37 ist für eine Justage des Durchflusses relativ gut zugänglich, da es außerhalb der Heliumtanks 5, 24 angeordnet ist.

Man beachte, dass in dieser Ausführungsform die Joule-Thomson-Kühleinheit ausschließlich mit Helium aus dem zweiten Heliumtank 5 bespeist wird. Für die beiden Heliumtanks 24, 5 sind hier separate Zugänge, vgl. Halsrohre 39, 39a, zur Befüllung mit flüssigem Helium notwendig.

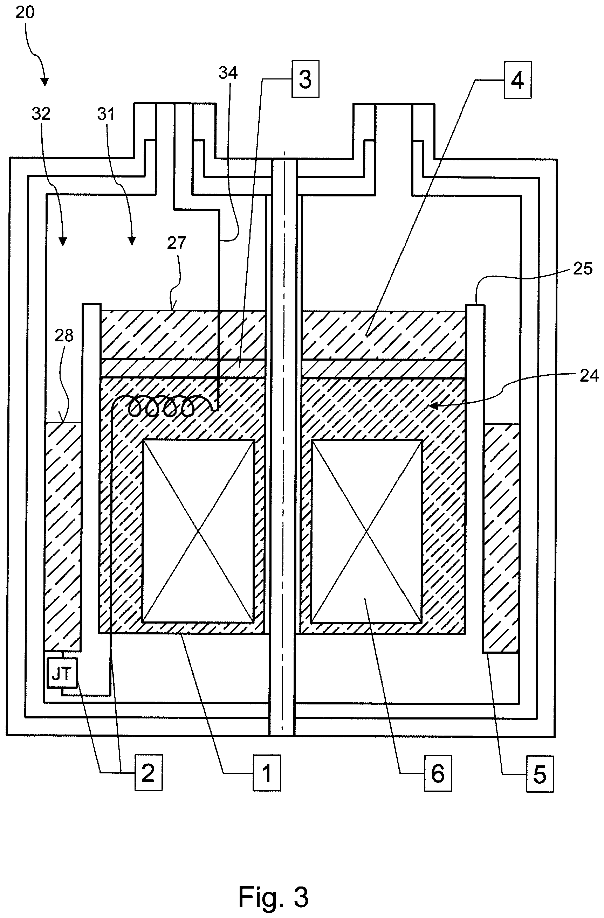

In der **Fig. 3** ist eine dritte Ausführungsform eines erfindungsgemäßen Kryostaten 20 gezeigt, die der zweiten Ausführungsform von Fig. 2 stark ähnelt, so dass nachfolgend nur die Unterschiede erläutert werden.

In der Ausführungsform von Fig. 3 sind der erste Gasraum 31 des ersten Heliumtanks 24, oberhalb der ersten Flüssigkeitsoberfläche 27, und der zweite Gasraum 32, oberhalb der zweiten Flüssigkeitsoberfläche 28, miteinander verbunden, so dass ein gemeinsamer Gasraum der beiden Heliumtanks 24, 5 eingerichtet ist. Zudem ist eine Überlaufkante 25 zwischen den Heliumtanks 24, 5 eingerichtet, so dass flüssiges Helium aus dem oberen Teil 4 des ersten Heliumtanks 24 in den zweiten Heliumtank 5 abfließen kann. Verdampftes Helium aus den Heliumtanks wird hier vor allem an der Flüssigkeitsoberfläche 27 und der Pumpleitung 34 im ersten Gasraum 31 rekondensiert und tropft in den oberen Teil 4.

*Verrohrungen zum Befüllen der beiden Heliumtanks mit flüssigem Helium*

Um bei der Inbetriebnahme des Systems sowohl den ersten, als auch den zweiten Tank effizient mit flüssigem Helium befüllen zu können, können die Halsrohre so angeordnet werden, dass einige (oder zumindest eines) direkt über dem ersten, und andere (oder zumindest ein anderes) direkt über dem zweiten Tank liegen. Alternativ oder zusätzlich kann eine Verrohrung das Befüllen der Heliumtanks unterstützen. Insbesondere kann im Inneren des Kryostaten eine Verrohrung zum Einfüllen von flüssigem Helium vorgesehen werden, mit der von demselben Halsrohr aus beide Heliumtanks befüllt werden können.

Die Verrohrung kann z.B. so angeordnet werden, dass zwei unterschiedliche Trichter (einer für den ersten Tank, ein anderer für den zweiten Tank) durch ein Halsrohr erreicht werden können. Ein Heliumtransferstab wird dann in den entsprechenden Trichter gesteckt, um den jeweiligen Tank zu befüllen.

Eine alternative Lösung besteht darin, den Transferstab und ein kryostatseitiges Gegenstück so auszuführen, dass durch die Drehstellung des Transferstabs bestimmt werden kann, ob flüssiges Helium in den ersten oder zweiten Tank gefüllt wird.

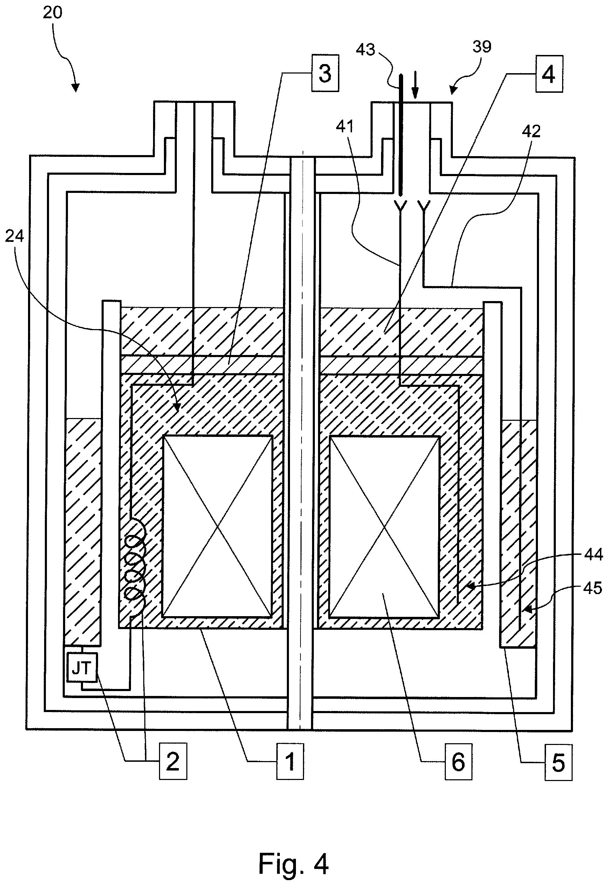

Die **Fig. 4** zeigt eine vierte Ausführungsform eines erfindungsgemäßen 20 Kryostaten, die weitgehend der Ausführungsform von Fig. 3 entspricht, so dass im Folgenden lediglich die wesentlichen Unterschiede erläutert werden.

Im Kryostaten 20 sind hier eine erste Verrohrung 41 und eine zweite Verrohrung 42 angeordnet. Jede Verrohrung 41, 42 weist einen eigenen Einfülltrichter unter dem Halsrohr 39 auf, über dem oder in dem ein durch das Halsrohr 39 ragender Heliumtransferstab 43 angeordnet werden kann. Flüssiges Helium, dass an einem unteren Ende aus dem Heliumtransferstab 43 austritt, kann dann in den durch den Heliumtransferstab 43 ausgewählten Einfülltrichter rinnen.

Die erste Verrohrung 41 führt in den ersten Heliumtank 24 durch den oberen Teil 4, die thermische Barriere 3 in den unteren Teil 1 und mündet in einem unteren Abschnitt 44 des ersten Heliumtanks 24, typischerweise im unteren Viertel des unteren Teils 1. Die zweite Verrohrung 42 führt in den zweiten Heliumtank 5 und mündet in einen unteren Abschnitt 45 des zweiten Heliumtanks 5, typischerweise im unteren Viertel des zweiten Heliumtanks 5.

In der gezeigten Ausführungsform ist der Wärmetauscher 38 im unteren Teil 1 neben der Magnetspule 6 angeordnet, und nicht über der Magnetspule 6. Dadurch kann im Einzelfall die Bauhöhe des Kryostaten 20 reduziert werden. Der Wärmetauscher 38 kann jedoch auch, ähnlich wie in Fig. 1 dargestellt, oberhalb der Magnetspule 6 angeordnet werden.

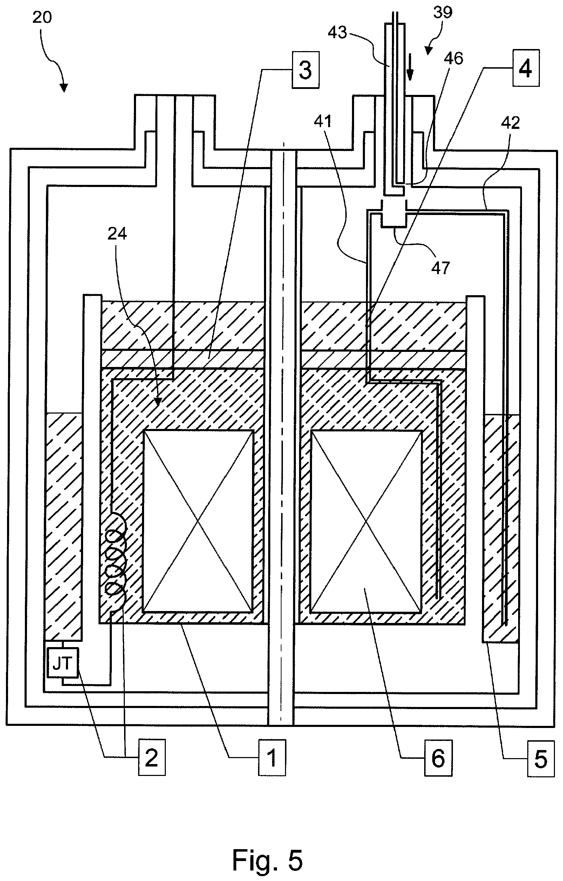

In der in **Fig. 5** gezeigten fünften Ausführungsform des Kryostaten 20, die wiederum der Ausführungsform von Fig. 4 ähnlich ist, so dass nur die wesentlichen Unterschiede erläutert werden, ist der Heliumtransferstab 43 mit einem seitlichen Auslass 46 nahe seines unteren Endes ausgebildet. Die erste Verrohrung 41 und die zweite Verrohrung 42 sind oberenends an eine Kopplungsstation 47 angeschlossen, die unter dem Halsrohr 39 angeordnet ist. Die Kopplungsstation 47 bildet ein Widerlager für den Heliumtransferstab 43 aus, der durch das Halsrohr 39 in die Kopplungsstation 47 von oben eingeschoben werden kann.

Der Heliumtransferstab 43 kann dabei in einer ersten Orientierung flüssiges Helium in die erste Verrohrung 41 einlaufen lassen. Alternativ kann der Heliumtransferstab 43 in einer zweiten Orientierung flüssiges Helium in die zweite Verrohrung 42 einlaufen lassen; in der in Fig. 5 gezeigten Drehstellung des Heliumtransferstabs 43 ist diese zweite Orientierung vorbereitet, so dass der Heliumtransferstab 43 nur noch in die Kopplungsstation 47 abgesenkt zu werden braucht, um den zweiten Heliumtank 5 über die zweite Verrohrung 42 zu befüllen.

Bei rotationssymmetrischem (kreisrundem) Bau der Kopplungsstation 47 bzw. dessen Aufnahmeöffnung und des Heliumtransferstabs 43 kann der Heliumtransferstab 43 in der Kopplungsstation 47 gedreht werden, um die Orientierung zu wechseln. Bevorzugt sind der Heliumtransferstab 43 und die Kopplungsstation 47 jedoch nicht rotationssymmetrisch gebaut, und der Heliumtransferstab 43 wird über der Kopplungsstation 47 in die gewünschte Orientierung gebracht und dann eingeschoben; der Heliumtransferstab 43 wird dann drehfest in der Kopplungsstation 47 gehalten.

*Zusätzliche aktive Kühleinrichtung*

Ein erfindungsgemäßer Kryostat bzw. ein erfindungsgemäßes Magnetsystem kann auch in Kombination mit einem aktiven Kühlsystem (aktive Kühleinrichtung, "Kühler"), insbesondere einem Pulsrohrkühler, betrieben werden.

Besondere Beachtung sollte dabei dem Szenario eines Kühlerausfalls geschenkt werden; bei einem Ausfall des Kühlers führt die Wärmeleitung über den oder die Kaltfinger des Kühlers zu einer beträchtlichen Wärmelast; diese sollte soweit möglich auf den Vorratstank (den zweiten Heliumtank) geleitet werden. Das kann dadurch erreicht werden, dass der Kühler über dem zweiten Tank angeordnet wird, und die Verbindung der Gasräume des ersten und zweiten Tanks so eng wie möglich gestaltet wird (eine untere Grenze kann sich aus der Anforderung ergeben, dass Helium in manchen Notfallszenarien - z.B. eines Vakuumbruchs - mit geringem Druckverlust durch die Verbindung strömen können sollte).

Eine Wärmelast, die durch Wärmeleitung in den Halsrohren zustande kommt, kann durch ein Verbindungselement aus einem hochleitfähigen Werkstoff (z.B. Kupfer) in den zweiten Tank abgeleitet werden.

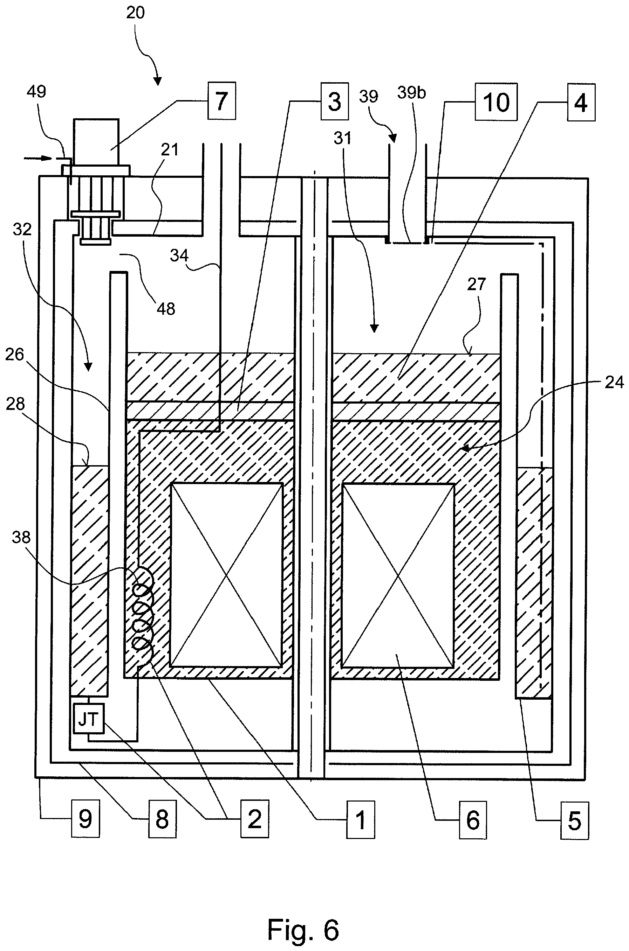

**Fig. 6** zeigt eine sechste Ausführungsform eines erfindungsgemäßen Kryostaten 20, ähnlich dem Kryostaten von Fig. 3, so dass nur die wesentlichen Unterschiede erläutert werden.

Oberhalb des zweiten Heliumtanks 5 ist eine (gegenüber der Joule-Thomson-Kühleinheit 2 zusätzliche) aktive Kühleinrichtung 7, hier ein Pulsrohrkühler bzw. dessen Kaltkopf, angeordnet. Zwischen dem zweiten Heliumtank 5 und dem ersten Heliumtank 24 ist eine Wandung 26 ausgebildet, die bis knapp unter die Decke der Innenbehälterwand 21 ragt. Die Wandung 26 schattet bezüglich der Kühleinrichtung 7 einen Großteil des ersten Heliumtanks 24 ab, und insbesondere auch den größten Teil der ersten Flüssigkeitsoberfläche 27. Die Konvektion von Heliumgas durch den relativ kleinen Spalt 48 zwischen Wandung 26 und Decke der Innenbehälterwand 21 ist gering. Weiterhin ist hier eine gut wärmeleitfähige Verbindung 10 aus Kupfer vorgesehen, die hier mit einem unteren Verschlussdeckel 39b am Halsrohr 39 verbunden ist und in das flüssige Helium im zweiten Heliumtank 5 führt. Durch diese Maßnahmen ist sichergestellt, dass eine Wärmelast (etwa bei Ausfall der Kühleinrichtung 7, oder auch bei Ausfall der Joule-Thomson-Kühleinheit 2) nur zu einem geringen Teil in den ersten Heliumtank 24 gelangt, und zu einem größeren Teil in den zweiten Heliumtank 5 eingeht. Entsprechend wird die supraleitende Magnetspule 6 vor der Wärmelast geschützt, so dass ein langer Überbrückungsbetrieb der supraleitenden Magnetspule 6, insbesondere bei Ausfall der aktiven Kühleinrichtung 7, möglich ist.

Während des Normalbetriebs wird an der aktiven Kühleinrichtung 7 durch eine Zuführung 49 Heliumgas, das durch die Pumpleitung 34 abgesaugt wurde, zurück in den Kryostaten 20 geführt. Das Heliumgas verflüssigt sich an der untersten Kühlstufe der Kühleinrichtung 7 und tropft in den zweiten Heliumtank 5, von wo es die Joule-Thomson-Kühleinheit 2 wieder absaugen kann. Der Kryostat 20 kann so mit einem geschlossenen Heliumkreislauf, also ohne Heliumverbrauch (Heliumverlust), betrieben werden.

Man beachte, dass der Wärmetauscher 38 hier wieder neben der supraleitenden Magnetspule 6 im unteren Teil 1 des ersten Heliumtanks 24 angeordnet ist.

*Ausführungsformen mit verengtem Zugangsrohr am ersten Heliumtank*

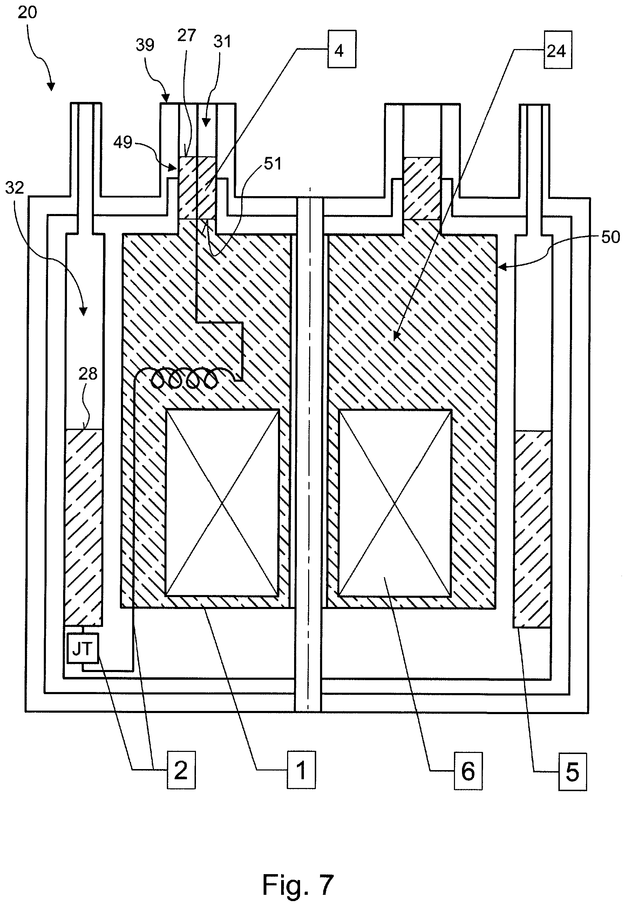

In der **Fig. 7** ist eine siebte Ausführungsform eines erfindungsgemäßen Kryostaten 20 gezeigt, die der Ausführungsform von Fig. 2 ähnelt, so dass wiederum nur die wesentlichen Unterschiede erläutert werden.

In dieser Ausführungsform umfasst der erste Heliumtank 24 ein Zugangsrohr 49 in einem Halsrohr 39 und einen darunter liegenden Abschnitt 50, der weiter ist als das Zugangsrohr 39. Der Abschnitt 50 ist vollständig mit supraflüssigem Helium bei ca. 2,2 K befüllt, ebenso ein unteres Stück des Zugangsrohrs 39 bis zu einer Grenzfläche 51. Oberhalb der Grenzfläche 51 ist im Zugangsrohr 39 bis zur ersten Flüssigkeitsoberfläche 27 normalflüssiges Helium bei ca. 4,2 K angeordnet.

Aufgrund der geringen (horizontalen) Querschnittsfläche im Zugangsrohr 49, die typischerweise maximal 1/10, bevorzugt maximal 1/20, und oft nur maximal 1/50 der (horizontalen) Querschnittsfläche im Abschnitt 50 beträgt, ist der Wärmeeintrag durch die Grenzfläche 51 vom oberen (mit normalflüssigem Helium befüllten) Teil 4 in den unteren (mit supraflüssigem Helium befüllten) Teil 1 des ersten Heliumtanks 24 so gering, dass die Kühlleistung der Joule-Thomson-Kühleinheit 2 dies ausgleichen kann.

In der gezeigten Ausführungsform sind der erste Gasraum 31 des ersten Heliumtanks 24, oberhalb der ersten Flüssigkeitsoberfläche 27, und der zweite Gasraum 32 des zweiten Heliumtanks 5, oberhalb der zweiten Flüssigkeitsoberfläche 28, voneinander getrennt. Die Joule-Thomson-Kühleinheit 2 saugt entsprechend direkt am zweiten Heliumtank 5.

*Ausführungsform mit horizontaler Raumtemperaturbohrung*

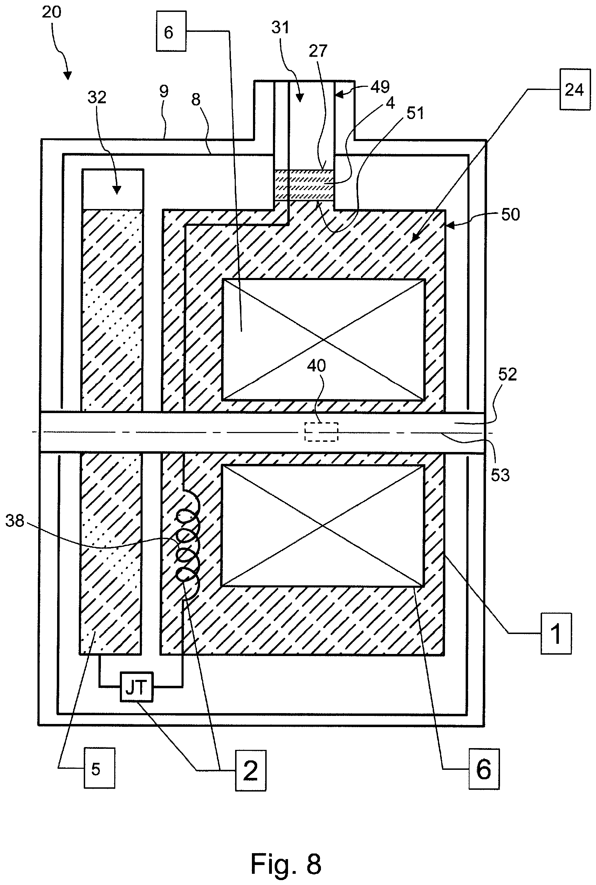

Die **Fig. 8** zeigt eine achte Ausführungsform eines erfindungsgemäßen Kryostaten 20, ähnlich zu der in Fig. 2 gezeigten Ausführungsform, so dass im Folgenden nur die wesentlichen Unterschiede erläutert werden.

Der Kryostat 20 mit Vakuumbehälterwand 9 und Strahlungsschild 8 verfügt über eine horizontale Raumtemperaturbohrung 52, die sowohl den ersten Heliumtank 24, als auch den zweiten Heliumtank 5 durchragt. Der zweite Heliumtank 5 ist seitlich neben dem ersten Heliumtank 24 angeordnet, und erstreckt sich hier über im Wesentlichen über denselben vertikalen Bereich wie der erste Heliumtank 24. Eine an einer Probenposition angeordnete Probe 40 in der Raumtemperaturbohrung 52 kann durch die supraleitende Magnetspule 6 einem starken, homogenen magnetischen Feld ausgesetzt werden. Der Kryostat 20 ist im Wesentlichen rotationssymmetrisch bezüglich der zentralen, horizontalen Achse 53 ausgebildet.

Der erste Heliumtank 24 verfügt - ähnlich wie die Ausführungsform von Fig. 7 - über ein gegenüber einem darunter liegenden Abschnitt 50 verengtes Zugangsrohr 49, in dem die Grenzfläche 51 zwischen normalflüssigem und supraflüssigem Helium angeordnet ist. Die Flüssigkeitsoberfläche 27 des normalflüssigen Heliums liegt hier unterhalb des oberseitigen Teils des Strahlungsschilds 8, was im Allgemeinen bevorzugt ist.

Der obere Teil 4 des ersten Heliumtanks 24 enthält nur eine relativ kleine Menge an flüssigem Helium. Hingegen kann im zweiten Heliumtank 5 eine große Menge an flüssigem Helium bevorratet werden, die von der Joule-Thomson-Kühleinheit 2 zur Kühlung des unteren Teils 1 bzw. der Magnetspule 6 eingesetzt werden kann. Der Wärmetauscher 38 ist hier seitlich neben der Magnetspule 6 angeordnet. Die Gasräume 31, 32 des ersten und zweiten Heliumtanks 24, 5 sind hier voneinander getrennt.

*Schlussbemerkung*

Zusammenfassend schlägt die vorliegende Erfindung vor, bei einem Kryostaten für unterkühltes (< 2,5 K) flüssiges Helium, der typischerweise zur Kühlung einer supraleitenden Magnetspule eingesetzt wird, zwei Heliumtanks vorzusehen, die bezüglich des jeweils enthaltenen flüssigen Heliums nicht miteinander kommunizieren. Eine Joule-Thomson-Kühleinheit, mit einem Wärmetauscher im unteren Teil des ersten Heliumtanks, nutzt im zweiten Heliumtank (Vorratstank) bevorratetes flüssiges Helium (> 4 K), um das unterkühlte flüssige Helium im unteren Teil des ersten Heliumtanks zu kühlen. Die Joule-Thomson-Kühleinheit saugt dafür entweder direkt flüssiges Helium aus dem zweiten Heliumtank an, oder sie saugt flüssiges Helium aus dem ersten Heliumtank an (typischerweise aus einem oberen Teil mit flüssigem Helium > 4 K) und flüssiges Helium kann über die Gasphase vom zweiten Heliumtank in den ersten Heliumtank überführt werden. Dadurch kann die Zeitdauer, in der das unterkühlte flüssige Helium des ersten Heliumtanks mittels eines Heliumvorrats im Kryostaten gekühlt werden kann, sehr lange eingerichtet werden. Der zweite Heliumtank kann zumindest teilweise neben dem ersten Heliumtank, insbesondere auch um den ersten Heliumtank herum, angeordnet werden, um eine geringe Bauhöhe des Kryostaten zu realisieren.

Im Rahmen der Erfindung kann somit die Haltezeit eines unterkühlten Magnetsystems erhöht werden, indem das Volumen des Heliumvorratstanks vergrößert wird. Dies kann ohne Veränderung der Bauhöhe erreicht werden, wenn der zweite Heliumtank thermisch isoliert neben oder um den ersten Heliumtank (der die Magnetspule enthält) angeordnet wird. Helium, das vom zweiten Heliumtank verdampft, kann in vorteilhaften Ausführungsformen im ersten Heliumtank rekondensieren. Der Kryostat sollte so konstruiert werden, dass ein möglichst großer Anteil der Gesamtwärmelast auf den zweiten Tank entfällt. Bevorzugt wird das Helium, das für den Betrieb der J-T Kühleinheit benötigt wird, aus dem zweiten Tank abgesaugt. Ein erfindungsgemäßer Kryostat kann auch in Kombination mit einem aktiven Kühlgerät, insbesondere mit einem Pulsrohrkühler, betrieben werden. Ein weiterer Vorteil der Erfindung besteht darin, dass im Falle eines Magnetquenchs im Wesentlichen nur Helium aus dem ersten Tank verloren geht, da der zweite Tank thermisch gut vom ersten isoliert werden kann, und die beim Quench entstehende Wärme deshalb nicht in den zweiten Tank geleitet wird.

**Patentansprüche**

1. Kryostat (20), mit

    - einem ersten Heliumtank (24), der in einem unteren Teil (1) mit flüssigem Helium, insbesondere superflüssigem Helium, mit einer Temperatur < 2,5 K und in einem oberen Teil (4) zumindest teilweise mit flüssigem Helium, insbesondere normalflüssigem Helium, mit einer Temperatur > 4 K befüllt ist, derart, dass der erste Heliumtank (24) einen ersten Bereich aufweist, der vom unteren Ende (29) des unteren Teils (1) bis zu einer ersten Flüssigkeitsoberfläche (27) im oberen Teil (4) durchgehend mit flüssigem Helium gefüllt ist,
    - mit einer Joule-Thomson-Kühleinheit (2), mit der das flüssige Helium im unteren Teil (1) des ersten Heliumtanks (24) durch expandierendes Helium über einen Wärmetauscher (38) gekühlt werden kann,
    - einem zweiten Heliumtank (5), der zumindest teilweise mit flüssigem Helium, insbesondere normalflüssigem Helium, mit einer Temperatur > 4 K befüllt ist, derart, dass der zweite Heliumtank (5) einen zweiten Bereich aufweist, der von einem unteren Ende (30) des zweiten Heliumtanks (5) bis zu einer zweiten Flüssigkeitsoberfläche (28) im zweiten Heliumtank (5) durchgehend mit flüssigem Helium gefüllt ist,

    wobei der erste Heliumtank (24) und der zweite Heliumtank (5) zumindest unterhalb der Flüssigkeitsoberflächen (27, 28) flüssigkeitsdicht voneinander abgetrennt sind,
    wobei die Joule-Thomson-Einheit (2) zur Kühlung des unteren Teils (1) des ersten Heliumtanks (24) flüssiges Helium dem zweiten Heliumtank (5)

    - direkt über Ansaugen von flüssigem Helium aus dem zweiten Heliumtank (5),
    - oder indirekt über eine Verdampfung von flüssigem Helium aus dem zweiten Heliumtank (5), Rekondensation des verdampften Heliums in den oberen Teil (4) des ersten Heliumtanks (24) und Ansaugen von flüssigem Helium aus dem ersten Heliumtank (24),

    entziehen kann,
    und wobei

    - zwischen dem oberen (4) und unterem Teil (1) des ersten Heliumtanks (24) eine thermische Barriere (3) angeordnet ist, in der sich ein Temperaturgradient von mindestens 1 Kelvin ausbildet und/oder eine Grenzfläche (51) zwischen superflüssigem Helium und normalflüssigem Helium verläuft, und/oder
    - der erste Heliumtank (24) ein Zugangsrohr (49) umfasst, welches enger ist als ein darunter liegender Abschnitt (50) des ersten Heliumtanks (24), derart, dass sich im Zugangsrohr (49) ein Temperaturgradient von wenigstens 1 Kelvin ausbildet und/oder eine Grenzfläche (51) zwischen superflüssigem Helium und normalflüssigen Helium im Zugangsrohr (49) liegt.

2. Kryostat (20) nach Anspruch 1, **dadurch gekennzeichnet, dass** der zweite Heliumtank (5) zumindest teilweise seitlich neben dem ersten Heliumtank (24) und/oder zumindest teilweise um den ersten Heliumtank (24) herum angeordnet ist.

3. Kryostat (20) nach einem der vorhergehenden Ansprüche, **dadurch gekennzeichnet, dass** der erste Heliumtank (24) und der zweite Heliumtank (5) so angeordnet sind, dass die erste Flüssigkeitsoberfläche (27) des flüssigen Heliums im ersten Heliumtank (24) höher liegen kann als die zweite Flüssigkeitsoberfläche (28) des flüssigen Heliums im zweiten Heliumtank (5),
insbesondere wobei die erste Flüssigkeitsoberfläche (27) des flüssigen Heliums im ersten Heliumtank (24) höher liegt als die zweite Flüssigkeitsoberfläche (28) des flüssigen Heliums im zweiten Heliumtank (5).

4. Kryostat (20) nach einem der vorhergehenden Ansprüche, **dadurch gekennzeichnet, dass** das Fassungsvermögen des zweiten Heliumtanks (5) für flüssiges Helium wenigstens 3 mal größer ist als das des oberen Teils (4) des ersten Heliumtanks (24).

5. Kryostat (20) nach einem der Ansprüche 1 bis 4, **dadurch gekennzeichnet, dass** er eine vertikale Raumtemperaturbohrung (22) umfasst, wobei der erste Heliumtank (24) um die Raumtemperaturbohrung (22) herum und der zweite Heliumtank (5) um den ersten Heliumtank (24) herum angeordnet ist.

6. Kryostat (20) nach einem der Ansprüche 1 bis 4, **dadurch gekennzeichnet, dass** er eine horizontale Raumtemperaturbohrung (52) umfasst, wobei der zweite Heliumtank (5) horizontal neben dem ersten Heliumtank (24) angeordnet ist, insbesondere wobei die Raumtemperaturbohrung (52) sowohl den ersten Heliumtank (24) als auch den zweiten Heliumtank (5) durchragt.

7. Kryostat (20) nach einem der vorhergehenden Ansprüche, **dadurch gekennzeichnet, dass** die Joule-Thomson-Kühleinheit (2) flüssiges Helium direkt aus dem zweiten Heliumtank (5) ansaugt, insbesondere an einem unteren Ende (30) des zweiten Heliumtanks (5).

8. Kryostat (20) nach einem der vorhergehenden Ansprüche, **dadurch gekennzeichnet, dass** ein erster Gasraum (31) des ersten Heliumtanks (24) und ein zweiter Gasraum (32) des zweiten Heliumtanks (5) Heliumgas führend miteinander verbunden sind.

9. Kryostat (20) nach Anspruch 8, **dadurch gekennzeichnet, dass** eine Heliumflussrate an der Joule-Thomson-Kühleinheit (2), welche flüssiges Helium aus dem ersten Heliumtank (24) ansaugt, so gewählt ist, dass bei den gegebenen Wärmelasten auf den ersten (24) und zweiten Heliumtank (5) entsprechend der besagten Heliumflussrate flüssiges Helium aus dem zweiten Heliumtank (5) verdampft und in den oberen Teil (4) des ersten Heliumtanks (24) rekondensiert.

10. Kryostat (20) nach Anspruch 8 oder 9, **dadurch gekennzeichnet, dass** der obere Teil (4) des ersten Heliumtanks (24) und der zweite Heliumtank (5) durch eine Wandung (26) getrennt sind, an deren oberen Ende eine Überlaufkante (25) ausgebildet ist, über die flüssiges Helium vom ersten Heliumtank (24) in den zweiten Heliumtank (5) überlaufen kann.

11. Kryostat (20) nach einem der vorhergehenden Ansprüche, **dadurch gekennzeichnet, dass** er eine aktive Kühleinrichtung (7), insbesondere einen Pulsrohrkühler, umfasst, mit der aus dem ersten Heliumtank (24) und/oder aus dem zweiten Heliumtank (5) verdampftes Helium verflüssigt werden kann.

12. Kryostat (20) nach Anspruch 11, **dadurch gekennzeichnet, dass** die aktive Kühleinrichtung (7) so im Kryostaten (20) angeordnet ist, dass bei Ausfall der Kühleinrichtung (7) eine Wärmelast zu einem größeren Anteil in den zweiten Heliumtank (5) eingebracht wird als in den ersten Heliumtank (24), so dass bei Ausfall der Kühleinrichtung (7) mehr Helium aus dem zweiten Heliumtank (5) verdampft als aus dem ersten Heliumtank (24).

13. Kryostat (20) nach Anspruch 12, **dadurch gekennzeichnet, dass** die Kühleinrichtung (7) oberhalb des zweiten Heliumtanks (5) angeordnet ist, und die erste Flüssigkeitsoberfläche (27) vollständig oder überwiegend abgeschattet ist, insbesondere durch eine zur Vakuumisolation des Kryostaten (20) gehörende Wandung (26).

14. Kryostat (20) nach einem der vorhergehenden Ansprüche, **dadurch gekennzeichnet, dass** eine Pumpleitung (34) der Joule-Thomson-Kühleinheit (2) durch den oberen Teil (4) des ersten Heliumtanks (24) und dann zumindest mit einem Teilabschnitt (34a) in einem Gasraum (31) oberhalb des ersten Heliumtanks (24) verläuft, so dass an der Außenseite der Pumpleitung (34) in dem Teilabschnitt (34a) verflüssigtes Helium von der Pumpleitung (34) in den oberen Teil (4) des ersten Heliumtanks (24) tropfen kann.

15. Kryostat (20) nach Anspruch 14, **dadurch gekennzeichnet, dass** die Pumpleitung (34) im oberen Teil (4) des ersten Heliumtanks (24) und/oder in dem Teilabschnitt (34a) wendelförmig oder mit Wärmetauscherrippen (35) ausgebildet ist.

16. Kryostat (20) nach einem der vorhergehenden Ansprüche, **dadurch gekennzeichnet, dass** für das erstmalige Befüllen mit Helium ausgehend von einem Halsrohr (39, 39a) des Kryostaten (20) eine erste Verrohrung (41) in einen unteren Abschnitt (44) des ersten Heliumtanks (24) und eine zweite Verrohrung (42) in einen unteren Abschnitt (45) des zweiten Heliumtanks (5) reicht.

## Claims

1. A cryostat (20), comprising

   - a first helium tank (24), which is filled in a lower part (1) with liquid helium, in particular superfluid helium, at a temperature < 2.5 K and in an upper part (4) at least partially with liquid helium, in particular normal fluid helium, at a temperature > 4 K, such that the first helium tank (24) has a first area that is continuously filled with liquid helium from a lower end (29) of the lower part (1) to a first liquid surface (27) in the upper part (4),
   - a Joule-Thomson cooling unit (2), with which the liquid helium in the lower part (1) of the first helium tank (24) can be cooled by expanding helium via a heat exchanger (38),
   - a second helium tank (5), which is at least partially filled with liquid helium, in particular normal fluid helium, at a temperature > 4 K, such that the second helium tank (5) has a second area that is continuously filled with liquid helium from a lower end (30) of the second helium tank (5) to a second liquid surface (28) in the second helium tank (5),

   wherein the first helium tank (24) and the second helium tank (5) are separated from each other in a liquid-tight manner at least below the liquid surfaces (27, 28),
   wherein the Joule-Thomson unit (2) for cooling the lower part (1) of the first helium tank (24) can withdraw liquid helium from the second helium tank (5)

   - directly via drawing liquid helium from the second helium tank (5),
   - or indirectly via evaporation of liquid helium from the second helium tank (5), recondensing the evaporated helium in the upper part (4) of the first helium tank (24), and drawing liquid helium from the first helium tank (24),

   and wherein

   - a thermal barrier (3) is arranged between the upper (4) and lower part (1) of the first helium tank (24), in which a temperature gradient of at least 1 Kelvin is formed and/or an interface (51) runs between superfluid helium and normal fluid helium and/or
   - the first helium tank (24) comprises an access tube (49) that is narrower than a section (50) of the first helium tank (24) lying thereunder, such that in the access tube (49), a temperature gradient of at least 1 Kelvin is formed and/or an interface (51) between the superfluid helium and normal fluid helium is present in the access tube (49).

2. The cryostat (20) according to claim 1, **characterized in that** the second helium tank (5) is arranged at least partially laterally adjacent to the first helium tank (24) and/or is arranged at least partially around the first helium tank (24).

3. The cryostat (20) according to one of the previous claims, **characterized in that** the first helium tank (24) and the second helium tank (5) are arranged such that the first liquid surface (27) of the liquid helium in the first helium tank (24) can be at a higher level than the second liquid surface (28) of the liquid helium in the second helium tank (5), in particular wherein the first liquid surface (27) of the liquid helium in the first helium tank (24) is at a higher level than the second liquid surface (28) of the liquid helium in the second helium tank (5).

4. The cryostat (20) according to one of the previous claims, **characterized in that** the capacity of the second helium tank (5) for liquid helium is at least three times greater than that of the upper part (4) of the first helium tank (24).

5. The cryostat (20) according to one of claims 1 through 4, **characterized by** comprising a vertical room temperature bore (22), wherein the first helium tank (24) is arranged around the room temperature bore (22) and the second helium tank (5) is arranged around the first helium tank (24).

6. The cryostat (20) according to one of claims 1 through 4, **characterized by** comprising a horizontal room temperature bore (52), wherein the second helium tank (5) is arranged horizontally adjacent to the first helium tank (24), in particular wherein the room temperature bore (52) extends through both the first helium tank (24) and the second helium tank (5).

7. The cryostat (20) according to one of the previous claims, **characterized in that** the Joule-Thomson cooling unit (2) draws in liquid helium directly from the second helium tank (5), in particular at a lower end (30) of the second helium tank (5).

8. The cryostat (20) according to one of the previous claims, **characterized in that** a first gas space (31) of the first helium tank (24) and a second gas space (32) of the second helium tank (5) are connected to each other is such a manner as to carry helium gas.

9. The cryostat (20) according to claim 8, **characterized in that** a helium flow rate at the Joule-Thomson cooling unit (2), which draws in liquid helium from the first helium tank (24), is selected such that at the given heat loads on the first (24) and second helium tank (5), liquid helium evaporates from the second helium tank (5) and recondenses in the upper part (4) of the first helium tank (24) corresponding to the said helium flow rate.

10. The cryostat (20) according to claims 8 or 9, **characterized in that** the upper part (4) of the first helium tank (24) and the second helium tank (5) are separated by a wall (26) on the upper end of which an overflow edge (25) is configured, over which liquid helium can overflow from the first helium tank (24) into the second helium tank (5).

11. The cryostat (20) according to one of the previous claims, **characterized in that** it comprises an active cooling device (7), in particular a pulse tube cooler, by means of which helium that evaporates from the first helium tank (24) and/or from the second helium tank (5) can be liquefied.

12. The cryostat (20) according to claim 11, **characterized in that** the active cooling device (7) is arranged in the cryostat (20) such that on failure of the cooling device (7), a greater portion of a heat load is introduced into the second helium tank (5) than into the first helium tank (24), so that on failure of the cooling device (7), more helium evaporates from the second helium tank (5) than from the first helium tank (24) .

13. The cryostat (20) according to claim 12, **characterized in that** the cooling device (7) is arranged above the second helium tank (5), and the first liquid surface (27) is completely or predominantly shaded, in particular by a wall (26) forming part of the vacuum insulation of the cryostat (20) .

14. The cryostat (20) according to one of the previous claims, **characterized in that** a pump line (34) of the Joule-Thomsen cooling unit (2) runs through the upper part (4) of the first helium tank (24) and then, at least with a partial section (34a), runs in a gas space (31) above the first helium tank (24), so that helium liquefied on the outer side of the pump line (34) in the partial section (34a) can drip from the pump line (34) into the upper part (4) of the first helium tank (24) .

15. The cryostat (20) according to claim 14, **characterized in that** the pump line (34) in the upper part (4) of the first helium tank (24) and/or in the partial section (34a) is configured helically or with heat exchanger fins (35).

16. The cryostat (20) according to one of the previous claims, **characterized in that** for the initial filling with helium starting from a neck tube (39, 39a) of the cryostat (20), a first tubing (41) extends into a lower section (44) of the first helium tank (24) and a second tubing (42) extends into a lower section (45) of the second helium tank (5).

**Revendications**

1. Cryostat (20) comprenant

- un premier réservoir d'hélium (24) qui est rempli dans une partie inférieure (1) avec de l'hélium liquide, en particulier de l'hélium superfluide, à une température < 2,5 K et dans une partie supérieure (4) au moins partiellement avec de l'hélium liquide, en particulier de l'hélium liquide normal, à une température > 4 K, de telle sorte que le premier réservoir d'hélium (24) comporte une première région qui est remplie en continu d'hélium liquide de l'extrémité inférieure (29) de la partie inférieure (1) à une première surface de liquide (27) dans la partie supérieure (4),
- une unité de refroidissement Joule-Thomson (2) au moyen de laquelle l'hélium liquide situé dans la partie inférieure (1) du premier réservoir d'hélium (24) peut être refroidi par détente d'hélium par le biais d'un échangeur de chaleur (38),
- un deuxième réservoir d'hélium (5) qui est au moins partiellement rempli d'hélium liquide, en particulier d'hélium liquide normal, à une température > 4 K, de telle sorte que le deuxième réservoir d'hélium (5) comporte une deuxième région qui est remplie en continu d'hélium liquide d'une extrémité inférieure (30) du deuxième réservoir d'hélium (5) jusqu'à une deuxième surface de liquide (28) dans le deuxième réservoir d'hélium (5),

le premier réservoir d'hélium (24) et le deuxième réservoir d'hélium (5) étant séparés l'un de l'autre de manière étanche à des liquides au moins au-dessous des surfaces de liquide (27, 28), l'unité Joule-Thomson (2) pouvant retirer de l'hélium liquide du deuxième réservoir d'hélium (5)

- directement par aspiration de l'hélium liquide du deuxième réservoir d'hélium (5),
- ou indirectement par évaporation d'hélium liquide du deuxième réservoir d'hélium (5), condensation à nouveau de l'hélium évaporé dans la partie supérieure (4) du premier réservoir d'hélium (24) et aspiration d'hélium liquide du premier réservoir d'hélium (24),

pour refroidir la partie inférieure (1) du premier réservoir d'hélium (24) et

- une barrière thermique (3) étant disposée entre la partie supérieure (4) et la partie inférieure (1) du premier réservoir d'hélium (24), barrière dans laquelle un gradient de température d'au moins 1 Kelvin se forme et/ou une interface (51) s'étend entre l'hélium superfluide et l'hélium liquide normal, et/ou
- le premier réservoir d'hélium (24) comprenant un tube d'accès (49) qui est plus étroit qu'une portion sous-jacente (50) du premier réservoir d'hélium (24) de telle sorte qu'un gradient de température d'au moins 1 Kelvin se forme dans le tube d'accès (49) et/ou une interface (51) soit située entre l'hélium super-liquide et l'hélium liquide normal dans le tube d'accès (49).

2. Cryostat (20) selon la revendication 1, **caractérisé en ce que** le deuxième réservoir d'hélium (5) est disposé au moins en partie latéralement à côté du premier réservoir d'hélium (24) et/ou au moins en partie autour du premier réservoir d'hélium (24).

3. Cryostat (20) selon l'une des revendications précédentes, **caractérisé en ce que** le premier réservoir d'hélium (24) et le deuxième réservoir d'hélium (5) sont disposés de telle sorte que la première surface de liquide (27) de l'hélium liquide dans le premier réservoir d'hélium (24) soit située plus haut que la deuxième surface de liquide (28) de l'hélium liquide dans le deuxième réservoir d'hélium (5), en particulier la première surface de liquide (27) de l'hélium liquide dans le premier réservoir d'hélium (24) étant située plus haut que la deuxième surface de liquide (28) de l'hélium liquide dans le deuxième réservoir d'hélium (5).

4. Cryostat (20) selon l'une des revendications précédentes, **caractérisé en ce que** la capacité du deuxième réservoir d'hélium (5) destiné à l'hélium liquide est au moins 3 fois supérieure à celle de la partie supérieure (4) du premier réservoir d'hélium (24).

5. Cryostat (20) selon l'une des revendications 1 à 4, **caractérisé en ce qu'**il comprend un alésage à température ambiante vertical (22), le premier réservoir d'hélium (24) étant disposé autour de l'alésage à température ambiante (22) et le deuxième réservoir d'hélium (5) étant disposé autour du premier réservoir d'hélium (24).

6. Cryostat (20) selon l'une des revendications 1 à 4, **caractérisé en ce qu'**il comprend un alésage à température ambiante horizontal (52), le deuxième réservoir d'hélium (5) étant disposé horizontalement à côté du premier réservoir d'hélium (24), en particulier l'alésage à température ambiante (52) faisant saillie à la fois aussi bien à travers le premier réservoir d'hélium (24) qu'à travers le deuxième réservoir d'hélium (5).

7. Cryostat (20) selon l'une des revendications précédentes, **caractérisé en ce que** l'unité de refroidissement Joule-Thomson (2) aspire l'hélium liquide directement du deuxième réservoir d'hélium (5), notamment à une extrémité inférieure (30) du deuxième réservoir d'hélium (5).

8. Cryostat (20) selon l'une des revendications précédentes, **caractérisé en ce qu'**un premier espace de gaz (31) du premier réservoir d'hélium (24) et un deuxième espace de gaz (32) du deuxième réservoir d'hélium (5) sont reliés entre eux de manière à conduire l'hélium gazeux.

9. Cryostat (20) selon la revendication 8, **caractérisé en ce qu'**un débit d'hélium au niveau de l'unité de refroidissement Joule-Thomson (2), qui aspire l'hélium liquide du premier réservoir d'hélium (24), est choisi de manière à ce que, pour des charges thermiques données exercées sur le premier réservoir d'hélium (24) et le deuxième réservoir d'hélium (5), l'hélium liquide s'évapore du deuxième réservoir d'hélium (5) et se condense à nouveau dans la partie supérieure (4) du premier réservoir d'hélium (24) conformément audit débit d'hélium.

10. Cryostat (20) selon la revendication 8 ou 9, **caractérisé en ce que** la partie supérieure (4) du premier réservoir d'hélium (24) et le deuxième réservoir d'hélium (5) sont séparés par une paroi (26) à l'extrémité supérieure de laquelle un bord de débordement (25) est formé par lequel l'hélium liquide peut déborder du premier réservoir d'hélium (24) dans le deuxième réservoir d'hélium (5).

11. Cryostat (20) selon l'une des revendications précédentes, **caractérisé en ce qu'**il comprend un dispositif de refroidissement actif (7), notamment un refroidisseur à tube pulsé, au moyen duquel de l'hélium évaporé du premier réservoir d'hélium (24) et/ou du deuxième réservoir d'hélium (5) peut être liquéfié.

12. Cryostat (20) selon la revendication 11, **caractérisé en ce que** le dispositif de refroidissement actif (7) est disposé dans le cryostat (20) de telle sorte que, en cas de défaillance du dispositif de refroidissement (7), une charge thermique est introduite en plus grande proportion dans le deuxième réservoir d'hélium (5) que dans le premier réservoir d'hélium (24) de sorte que, en cas de défaillance du dispositif de refroidissement (7), davantage d'hélium s'évapore du deuxième réservoir d'hélium (5) que du premier réservoir d'hélium (24).

13. Cryostat (20) selon la revendication 12, **caractérisé en ce que** le dispositif de refroidissement (7) est disposé au-dessus du deuxième réservoir d'hélium (5), et la première surface de liquide (27) est totalement ou en grande partie masquée, notamment par une paroi (26) appartenant à une isolation sous vide du cryostat (20).

14. Cryostat (20) selon l'une des revendications précédentes, **caractérisé en ce qu'**une conduite de pompage (34) de l'unité de refroidissement Joule-Thomson (2) s'étend à travers la partie supérieure (4) du premier réservoir d'hélium (24) puis au moins par une portion (34a) dans un espace de gaz (31) situé au-dessus du premier réservoir d'hélium (24) de sorte que, du côté extérieur de la conduite de pompage (34), l'hélium liquéfié dans la portion (34a) peut s'égoutter de la conduite de pompage (34) dans la partie supérieure (4) du premier réservoir d'hélium (24).

15. Cryostat (20) selon la revendication 14, **caractérisé en ce que** la conduite de pompage (34), située dans la partie supérieure (4) du premier réservoir d'hélium (24) et/ou dans la portion (34a), a une forme hélicoïdale ou est conçue avec des ailettes d'échangeur de chaleur (35).

16. Cryostat (20) selon l'une des revendications précédentes, **caractérisé en ce que**, pour effectuer le remplissage initial avec de l'hélium, une première tuyauterie (41) s'étend jusque dans une portion inférieure (44) du premier réservoir d'hélium (24), et une deuxième tuyauterie (42) s'étend jusque dans une portion inférieure (45) du deuxième réservoir d'hélium (5), depuis un col tubulaire (39, 39a) du cryostat (20).

Fig. 1

Fig. 2

Fig. 3

Fig. 4

Fig. 5

EP 3 230 666 B1

Fig. 6

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102010028750 B4
- JP 2001330328 A
- JP S611962 A
- JP H0979677 A

### In der Beschreibung aufgeführte Nicht-Patentliteratur

- **L.C. YANG et al.** *Cryogenics,* April 1981, 207-212